# EUROPEAN PATENT APPLICATION

(11) **EP 4 818 767 A1**
(43) Date of publication of application: **07.10.2026**
(21) Application number: 24897619.3
(22) Date of filing: 27.11.2024
(51) Int. Cl.: G02B 1/14, B32B 7/023, B32B 27/18, G02B 1/10, G02B 1/111, G02B 5/30, G09F 9/00

(54) **OPTICAL SHEET, SHEET ARTICLE, POLARIZING PLATE, DISPLAY DEVICE, PANEL, OPTICAL SHEET SELECTION METHOD, AND OPTICAL SHEET MANUFACTURING METHOD**

(30) Priority: 28.11.2023 JP 2023201114
(71) Applicant: Dai Nippon Printing Co., Ltd., Tokyo-to 162-8001 (JP)
(72) Inventor: HATA, Kentaro, Tokyo-to 1628001 (JP); KAWASE, Michihiro, Tokyo-to 1628001 (JP); KUNIYOSHI, Suzuka, Tokyo-to 1628001 (JP); KATO, Emiko, Tokyo-to 1628001 (JP); SEIKE, Osamu, Tokyo-to 1628001 (JP); DEGUCHI, Risa, Tokyo-to 1628001 (JP); TAKEI, Michiaki, Tokyo-to 1628001 (JP); IKEDA, Keisuke, Tokyo-to 1628001 (JP); MIZOSHIRI, Makoto, Tokyo-to 1628001 (JP)
(74) Representative: Cabinet Beau de Loménie
(86) International application number: PCT/JP2024/042065
(87) International publication number: WO 2025/115935

(57) **Abstract**

An optical sheet includes a first surface and a second surface opposing the first surface. The optical sheet includes a substrate and a functional layer in this order from the second surface toward the first surface. The functional layer contains a binder component and metal oxide particles. The average area of Voronoi regions having, as seed points, the metal oxide particles observed on the first surface is 2500 nm² or more.

## Description

### Technical Field

The present disclosure relates to an optical sheet, a sheet-like article, a polarizing plate, a display apparatus, a panel, a method for selecting an optical sheet, and a method for producing an optical sheet.

### Background Art

As disclosed in PTL 1, optical sheets including a functional layer are known. The functional layer contains metal oxide particles. The functional layer is expected to exhibit an optical function derived from the metal oxide particles. In PTL 1, the functional layer functions as a low-reflection layer containing hollow silica particles.

The metal oxide particles may detach from the functional layer during the use of the optical sheet. The metal oxide particles may deform during the use of the optical sheet. Detachment or deformation of the metal oxide particles results in low scratch resistance of the optical sheet including the functional layer.

PTL 1: WO2021/020504

### Disclosure of Invention

An object of the present disclosure is to improve the scratch resistance of an optical sheet including a functional layer.

An optical sheet according to an embodiment of the present disclosure is
an optical sheet including a first surface and a second surface opposing the first surface,
the optical sheet including a substrate and a functional layer in this order from the second surface toward the first surface,
wherein the functional layer contains a binder component and metal oxide particles, and
an average area of Voronoi regions having, as seed points, the metal oxide particles observed on the first surface is 2500 nm² or more.

A sheet-like article according to an embodiment of the present disclosure includes a plurality of optical sheets according to the embodiment of the present disclosure.

A polarizing plate according to an embodiment of the present disclosure includes a first protective sheet, a polarizer, and a second protective sheet,
wherein at least one of the first protective sheet and the second protective sheet is an optical sheet according to the embodiment of the present disclosure.

A display apparatus according to an embodiment of the present disclosure includes an image forming apparatus; and
an optical sheet according to the embodiment of the present disclosure stacked to the image forming apparatus.

A panel according to an embodiment of the present disclosure includes a bonding target article; and
an optical sheet according to the embodiment of the present disclosure bonded to the bonding target article.

A method for selecting an optical sheet according to an embodiment of the present disclosure includes,
with respect to an optical sheet having a first surface and a second surface opposing the first surface,
the optical sheet including a substrate and a functional layer in this order from the second surface toward the first surface,
wherein the functional layer contains a binder component and metal oxide particles,
measuring an average area of Voronoi regions having, as seed points the metal oxide particles observed on the first surface; and
selecting an optical sheet in which the average area (nm²) of the Voronoi regions is a predetermined value or more.

A method for producing an optical sheet according to an embodiment of the present disclosure includes:
preparing an optical sheet having a first surface and a second surface opposing the first surface,
wherein the optical sheet includes a substrate and a functional layer in this order from the second surface toward the first surface, and
wherein the functional layer contains a binder component and metal oxide particles; and
selecting an optical sheet in which an average area (nm²) of Voronoi regions having, as seed points the metal oxide particles observed on the first surface is a predetermined value or more.

According to the present disclosure, the scratch resistance of an optical sheet including a functional layer can be improved.

### Brief Description of Drawings

[Fig. 1] Fig. 1 is a diagram for explaining an embodiment and is a cross-sectional view illustrating an example of an optical sheet.
[Fig. 2] Fig. 2 is a plan view for explaining Voronoi regions and seed points.
[Fig. 3] Fig. 3 is a diagram corresponding to Fig. 1 and is a cross-sectional view illustrating another example of an optical sheet.
[Fig. 4] Fig. 4 is a perspective view illustrating an example of a sheet-like article including an optical sheet.
[Fig. 5] Fig. 5 is a cross-sectional view illustrating an example of a polarizing plate including an optical sheet.
[Fig. 6] Fig. 6 is a cross-sectional view illustrating an example of a display apparatus including an optical sheet.
[Fig. 7] Fig. 7 is a cross-sectional view illustrating an example of a panel including an optical sheet.
[Fig. 8A] Fig. 8A is an observation image showing a first surface of an optical sheet according to Example 1.
[Fig. 8B] Fig. 8B is an image obtained by subjecting the image showing the first surface of the optical sheet according to Example 1 to binarization processing.
[Fig. 8C] Fig. 8C is an image showing a distribution of center positions of metal oxide particles observed on the first surface of the optical sheet according to Example 1.
[Fig. 9A] Fig. 9A is an image showing a Voronoi diagram obtained from an observation image of the first surface of the optical sheet according to Example 1.
[Fig. 9B] Fig. 9B is an image showing a Voronoi diagram obtained from an observation image of a first surface of an optical sheet according to Example 2.
[Fig. 9C] Fig. 9C is an image showing a Voronoi diagram obtained from an observation image of a first surface of an optical sheet according to Example 3.
[Fig. 9D] Fig. 9D is an image showing a Voronoi diagram obtained from an observation image of a first surface of ane optical sheet according to Example 4.
[Fig. 9E] Fig. 9E is an image showing a Voronoi diagram obtained from an observation image of a first surface of an optical sheet according to Example 5.
[Fig. 9F] Fig. 9F is an image showing a Voronoi diagram obtained from an observation image of a first surface of ane optical sheet according to Comparative Example 1.
[Fig. 9G] Fig. 9G is an image showing a Voronoi diagram obtained from an observation image of a first surface of an optical sheet according to Comparative Example 2.

### Description of Embodiments

An embodiment of the present disclosure is directed to the following <1> to <20>.
<1> An optical sheet including a first surface and a second surface opposing the first surface,
   the optical sheet including a substrate and a functional layer in this order from the second surface toward the first surface,
   wherein the functional layer contains a binder component and metal oxide particles, and
   an average area of Voronoi regions having, as seed points, the metal oxide particles observed on the first surface is 2500 nm² or more.
<2> The optical sheet according to <1>, wherein the average area of the Voronoi regions is 3200 nm² or more.
<3> The optical sheet according to <1> or <2>, wherein a standard deviation of areas of the Voronoi regions is 950 nm² or more.
<4> The optical sheet according to any one of <1> to <3>, wherein a ratio of a standard deviation of areas of the Voronoi regions to the average area of the Voronoi regions is 0.30 or more.
<5> The optical sheet according to any one of <1> to <4>, wherein, when a "Jumbo Wearaser (registered trademark), CS-6" manufactured by TABER Industries is used as a slider, a coefficient of kinetic friction between the first surface and the slider having a load of 200 g applied thereto is 0.95 or less.
<6> The optical sheet according to any one of <1> to <5>, having resistance to a scratch resistance test conducted on the first surface using steel wool under conditions below:
   Scratch resistance test: steel wool #0000 as a slider; load of 1000 g; moving speed of 80 mm/s; one-way stroke of 40 mm; and 1000 reciprocations.
<7> The optical sheet according to any one of <1> to <6>, having resistance to a scratch resistance test conducted on the first surface using rubber under conditions below:
   Scratch resistance test: "Jumbo Wearaser (registered trademark), model No. CS-6" manufactured by TABER Industries as a slider; load of 200 g; moving speed of 200 mm/s; one-way stroke of 50 mm; and 150 reciprocations.
<8> The optical sheet according to any one of <1> to <7>, wherein the functional layer contains hollow silica particles.
<9> The optical sheet according to any one of <1> to <8>, wherein the functional layer contains alumina particles.
<10> The optical sheet according to any one of <1> to <9>, wherein the functional layer contains a siloxane compound.
<11> The optical sheet according to any one of <1> to <10>, wherein the functional layer contains a cured product of an ultraviolet-curable siloxane compound-containing composition.
<12> The optical sheet according to any one of <1> to <11>, wherein the functional layer has a thickness of 60 nm or more and 120 nm or less.
<13> The optical sheet according to any one of <1> to <12>, including a resin layer located between the substrate and the functional layer,
   wherein the resin layer contains a cured product of a curable resin composition.
<14> A sheet-like article including a plurality of the optical sheets according to any one of <1> to <13>.
<15> The sheet-like article according to <14>, wound about a winding axis.
<16> A polarizing plate including a first protective sheet, a polarizer, and a second protective sheet,
   wherein at least one of the first protective sheet and the second protective sheet includes the optical sheet according to any one of <1> to <13>.
<17> A display apparatus including an image forming apparatus; and
   the optical sheet according to any one of <1> to <13> stacked to the image forming apparatus.
<18> A panel including an article; and
   the optical sheet according to any one of <1> to <13> bonded to the article.
<19> A method for selecting an optical sheet, the method including, with respect to an optical sheet having a first surface and a second surface opposing the first surface,
   the optical sheet including a substrate and a functional layer in this order from the second surface toward the first surface,
   wherein the functional layer contains a binder component and metal oxide particles,
   measuring an average area of Voronoi having, as seed points, the metal oxide particles observed on the first surface; and
   selecting an optical sheet in which the average area (nm²) of the Voronoi regions is a predetermined value or more.
<20> A method for producing an optical sheet, the method including:
   preparing an optical sheet having a first surface and a second surface opposing the first surface,
   wherein the optical sheet including a substrate and a functional layer in this order from the second surface toward the first surface, and
   wherein the functional layer contains a binder component and metal oxide particles; and
   selecting an optical sheet in which an average area (nm²) of Voronoi regions having, as seed points, the metal oxide particles observed on the first surface is a predetermined value or more.

Details of an embodiment of the present disclosure will be described below. In the drawings attached to the present description, scales, dimensional ratios in vertical and horizontal directions, and the like are appropriately changed and exaggerated from those of actual ones, for convenience of illustration and ease of understanding.

In the present description, terms such as "sheet", "film", and "plate" are not distinguished from one another solely on the basis of differences in designation. For example, an "optical sheet" cannot be distinguished from, for example, members referred to as an optical film or an optical plate solely on the basis of differences in designation.

In the present description, a plurality of candidates for upper limits and a plurality of candidates for lower limits relating to a numerical range may be described in separate sentences. In such a description, the numerical range may be constituted by combining any one candidate for an upper limit and any one candidate for a lower limit. As an example, the following description is examined: "Parameter B may be A1 or more, may be A2 or more, or may be A3 or more. Parameter B may be A4 or less, may be A5 or less, or may be A6 or less." In this example, the numerical range of parameter B may be A1 or more and A4 or less, may be A1 or more and A5 or less, may be A1 or more and A6 or less, may be A2 or more and A4 or less, may be A2 or more and A5 or less, may be A2 or more and A6 or less, may be A3 or more and A4 or less, may be A3 or more and A5 or less, or may be A3 or more and A6 or less.

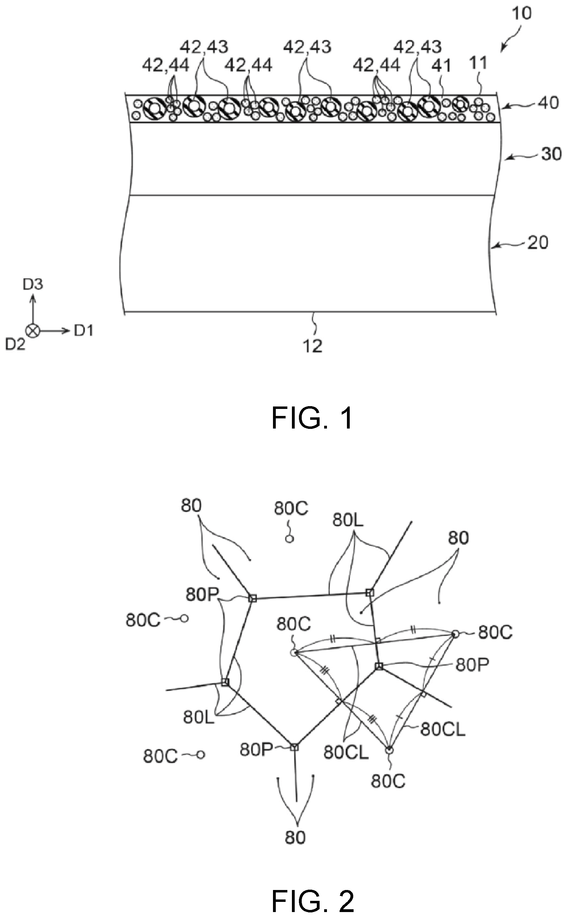

To clarify directional relationships among the drawings, in some drawings, common directions are indicated by arrows provided with common reference signs. The tip side of each arrow is a first side of each direction. The side opposite to the tip of each arrow is a second side of each direction. An arrow directed toward the back of the drawing sheet along a direction perpendicular to the drawing sheet is indicated by a circle with × inside, for example, as shown in Fig. 1.

### <<<Optical Sheet 10>>>

As shown in Fig. 1, an optical sheet 10 according to the present embodiment includes a first surface 11 and a second surface 12. The optical sheet 10 includes a substrate 20 and a functional layer 40 in this order from the second surface 12 toward the first surface 11. The functional layer 40 contains a binder component 41 and metal oxide particles 42. The functional layer 40 can exhibit a function derived from the metal oxide particles 42. The functional layer 40 may be one or more selected from a low-reflection layer or a reflection-suppressing layer, an antifouling layer, a hard coat layer, and an antistatic layer.

As an example, the functional layer 40 may contain hollow silica particles 43 as the metal oxide particles 42. The hollow silica particles 43 are silica particles having voids. The hollow silica particles 43 have a hollow structure. The hollow silica particles 43 have a low refractive index due to the structure. The functional layer 40 containing the hollow silica particles 43 as the metal oxide particles 42 has a refractive index lower than the refractive index of the binder component 41. By using the functional layer 40 having a low refractive index, reflection at the first surface 11 can be suppressed. The functional layer 40 having a low refractive index functions as a low-reflection layer or a reflection-suppressing layer.

During use of the optical sheet, an external force may be applied to the optical sheet. For example, the optical sheet may be rubbed. When an external force is applied to the optical sheet, the metal oxide particles may detach from the functional layer. When an external force is applied to the optical sheet, the metal oxide particles may deform. Due to detachment or deformation of the metal oxide particles, defects such as scratches are likely to occur on the surface of the optical sheet. The thickness of the functional layer is typically smaller than the thickness of the substrate. When an external force is applied to the optical sheet, the functional layer may detach from the optical sheet. The optical sheet having the functional layer tends to have poor scratch resistance.

In the functional layer containing hollow silica particles as the metal oxide particles, the hollow silica particles may detach from the functional layer during use of the optical sheet. During use of the optical sheet, the hollow silica particles are likely to be crushed because they have voids. Due to detachment or deformation of the hollow silica particles, defects such as scratches are likely to occur on the surface of the optical sheet. The thickness of the functional layer serving as a low-refractive-index layer or a reflection-suppressing layer is about 100 nm. The functional layer serving as a low-refractive-index layer or a reflection-suppressing layer is likely to detach and be scratched. The optical sheet containing hollow silica particles has poor scratch resistance.

### <<Average Area of Voronoi Regions>>

In the optical sheet 10 according to the present embodiment, the average area of Voronoi regions having, as seed points, the metal oxide particles 42 observed on the first surface 11 is 2500 nm² or more. In the optical sheet 10 according to the present embodiment in which the average area of Voronoi regions having, as seed points, the metal oxide particles 42 observed on the first surface 11 is 2500 nm² or more, the first surface 11 has excellent scratch resistance. In the optical sheet 10 in which the average area of Voronoi regions having, as seed points, the metal oxide particles 42 observed on the first surface 11 is 2500 nm² or more, the first surface 11 consistently has particularly excellent scratch resistance. Details of the reason for the improvement in scratch resistance are not clear, but it is presumed that the following matters contribute to improvement in the scratch resistance. However, the present disclosure is not bound by the following presumption.

As shown in Fig. 2, a Voronoi region 80 is a region partitioned by Voronoi boundaries 80L. One Voronoi region 80 is defined for each seed point 80C. As shown in Fig. 2, a Voronoi boundary 80L is a bisector of two seed points 80C. A Voronoi boundary 80L as a bisector of two seed points 80C is orthogonal to a straight line 80CL connecting the two seed points 80C. The two seed points 80C defining one Voronoi boundary 80L are seed points 80C corresponding to two Voronoi regions 80 partitioned by the Voronoi boundary 80L. An intersection point of Voronoi boundaries 80L is a Voronoi point 80P. One Voronoi point 80P is a boundary point of three or more Voronoi regions 80. Distances from three or more seed points 80C respectively corresponding to the three or more Voronoi regions 80 to the Voronoi point 80P are the same.

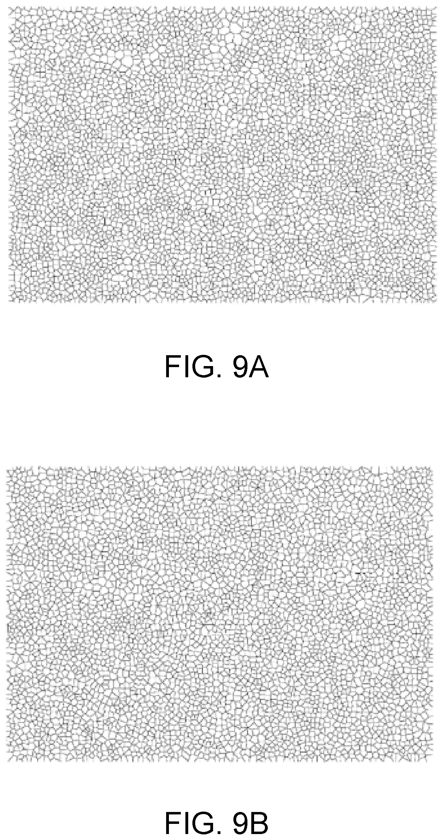

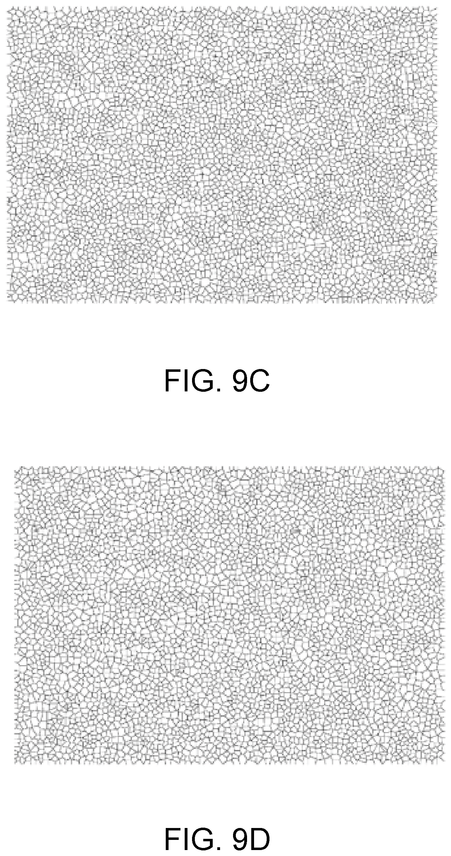

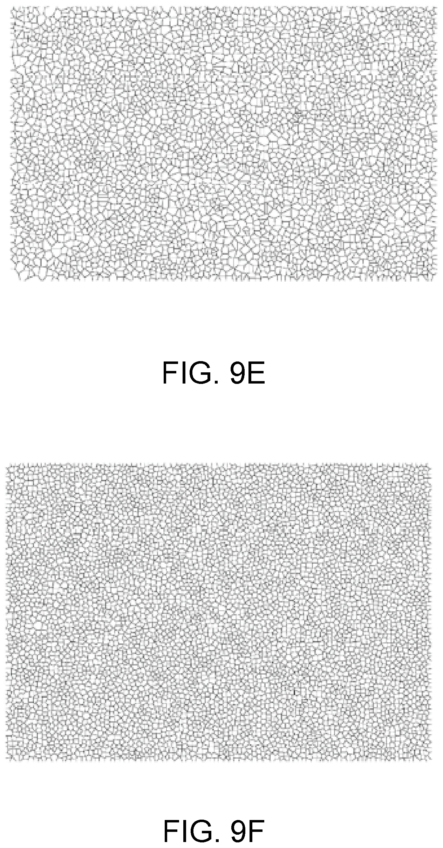

Figs. 9A to 9G show Voronoi diagrams. A Voronoi diagram is a diagram in which a plane region is divided for each Voronoi region 80 corresponding to each seed point 80C. A Voronoi diagram may be regarded as a diagram in which a plane on which a large number of seed points 80C are dispersed is divided for each nearest seed point 80C.

The average area of the Voronoi regions is an index of the density, on the first surface 11, of the metal oxide particles 42 located on the first surface 11. Setting a lower limit for the average area of the Voronoi regions indicates that the metal oxide particles 42 serving as seed points are sparsely located on the first surface 11. In order to impart a certain function to the functional layer 40, it is necessary for the functional layer 40 to contain the metal oxide particles 42 in a predetermined amount or a predetermined proportion. By limiting the amount of metal oxide particles 42 appearing on the first surface 11 under this restriction, adhesion between the binder component 41 and the metal oxide particles 42 in the vicinity of the first surface 11 and the surface state of the first surface 11 may be improved. As a result, it is presumed that the scratch resistance of the first surface 11 constituted by the functional layer 40 is enhanced.

In PTL 1 (WO2021/020504) described above, inorganic oxide particles are used to form protrusions on a surface. The metal oxide particles in PTL 1 are expected to protect hollow silica particles by forming protrusions on the surface. In the present embodiment, the metal oxide particles 42 are used in expectation of an action greatly different from that of PTL 1. The optical sheet 10 according to the present embodiment can achieve scratch resistance significantly superior to that of PTL 1, while having a configuration greatly different from that of PTL 1 also in terms of surface shape. In this respect, the advantageous effects according to the present embodiment are remarkable effects greatly beyond a range predictable from the technical level at the time of filing of the present application.

The average area of the Voronoi regions may be 2500 nm² or more as described above, may be 2900 nm² or more, may be 3000 nm² or more, may be 3200 nm² or more, may be 3500 nm² or more, or may be 3600 nm² or more.

It is not necessary to particularly set an upper limit of the average area of the Voronoi regions. An upper limit of the average area of the Voronoi regions may be set from the viewpoint of enhancing a function of the functional layer 40 derived from the metal oxide particles 42. The average area of the Voronoi regions may be 7000 nm² or less, may be 6000 nm² or less, may be 5000 nm² or less, or may be 4900 nm² or less.

The average area of the Voronoi regions may be 2500 nm² or more and 7000 nm² or less, may be 2900 nm² or more and 7000 nm² or less, may be 3000 nm² or more and 7000 nm² or less, may be 3200 nm² or more and 7000 nm² or less, may be 3500 nm² or more and 7000 nm² or less, or may be 3600 nm² or more and 7000 nm² or less. The average area of the Voronoi regions may be 2500 nm² or more and 6000 nm² or less, may be 2900 nm² or more and 6000 nm² or less, may be 3000 nm² or more and 6000 nm² or less, may be 3200 nm² or more and 6000 nm² or less, may be 3500 nm² or more and 6000 nm² or less, or may be 3600 nm² or more and 6000 nm² or less. The average area of the Voronoi regions may be 2500 nm² or more and 5000 nm² or less, may be 2900 nm² or more and 5000 nm² or less, may be 3000 nm² or more and 5000 nm² or less, may be 3200 nm² or more and 5000 nm² or less, may be 3500 nm² or more and 5000 nm² or less, or may be 3600 nm² or more and 5000 nm² or less. The average area of the Voronoi regions may be 2500 nm² or more and 4900 nm² or less, may be 2900 nm² or more and 4900 nm² or less, may be 3000 nm² or more and 4900 nm² or less, may be 3200 nm² or more and 4900 nm² or less, may be 3500 nm² or more and 4900 nm² or less, or may be 3600 nm² or more and 4900 nm² or less.

### <Method for Calculating Average Area of Voronoi Regions>

The average area of the Voronoi regions is defined as a value determined by the following procedure. The following procedure for obtaining the average area of the Voronoi regions includes a step of obtaining an observation image of the first surface 11, a step of identifying seed points from the observation image, and a step of identifying Voronoi regions from the seed points and determining areas of the Voronoi regions.

### (Step of Obtaining Observation Image of First Surface)

The step of obtaining an observation image of the first surface is carried out as follows. A sample having a size of 5 mm × 5 mm is cut from the optical sheet 10 to be evaluated. Conductive double-sided tape is attached to the entire area of a surface of the sample corresponding to the second surface 12 of the optical sheet 10. The conductive double-sided tape attached to the sample is attached to a flat sample stage. In this manner, the sample is fixed to the flat sample stage using the conductive double-sided tape. The flat sample stage is an accessory of a scanning electron microscopy (SEM) used for observation of the sample. The conductive double-sided tape is not particularly limited. The conductive double-sided tape may be carbon tape for SEM using an aluminum substrate, manufactured by Nisshin EM Co., Ltd.

Carbon paste is applied to four corners of the sample fixed to the flat sample stage. The carbon paste is not particularly limited. The carbon paste may be Colloidal Graphite No. 7141 (solvent: isopropanol), manufactured by Nisshin EM Co., Ltd.

Next, a PtPd-deposited film is formed on the sample using an ion sputtering apparatus. Ion sputtering conditions are as follows. Ar gas is introduced into a chamber containing the sample.
· Target: PtPd
· Degree of vacuum: 8 Pa
· Discharge current: 15 mA
· Deposition time: 15 seconds

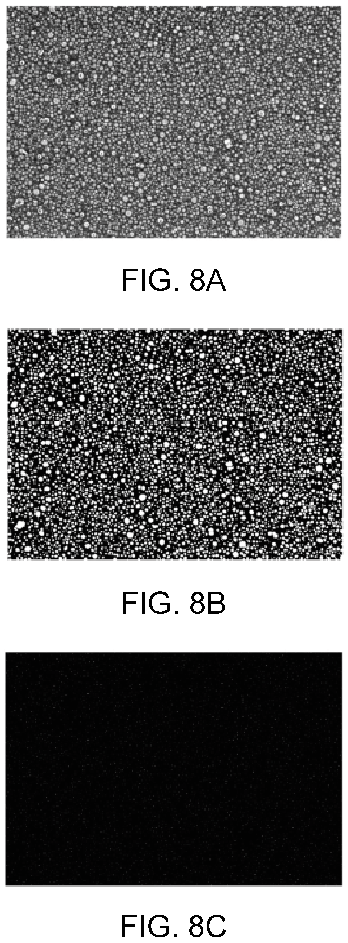

After the formation of the deposition film, the standard sample stage to which the sample is fixed is attached to a standard sample holder of a scanning electron microscope. An observation image of a surface of the sample corresponding to the first surface 11 of the optical sheet 10 to be evaluated is obtained under the following observation conditions of the scanning electron microscope. As the scanning electron microscope, an ultrahigh-resolution field-emission scanning electron microscope SU-9000 manufactured by Hitachi High-Technologies Corporation is used. Fig. 8A shows an example of the observation image.
· Measurement mode: SE
· Acceleration voltage: 1.0 kV
· Emission current: 10 µA
· WD (working distance): 3 mm or more and 3.5 mm or less
· Lens mode: High
· Observation magnification: 25000-fold
· Data size: 1280 pixels × 960 pixels
· Pixel size: 3.96875 nm

### (Step of Identifying Seed Points from Observation Image)

The step of identifying seed points from the observation image obtained as described above is carried out as follows. From the observation image, only unnecessary portions other than an image of the sample, such as a scale bar, are removed. By removing the unnecessary portions, image data for image processing are obtained.

Next, the image data are subjected to binarization processing. By the binarization processing, bright portions of the image data are rendered as white portions, and dark portions of the image data are rendered as black portions. An image in which circular white portions are dispersed in a black background is obtained. The white portions generally appear at positions where the metal oxide particles 42 are present.

For the binarization processing, ImageJ and Fiji are used as image processing software. ImageJ is open-source, public-domain image processing software the development of which was started at the National Institutes of Health in the United States. Fiji is a plugin package for ImageJ. For the binarization processing, the following Fiji commands are used. By binarization processing under the following conditions, a white portion is generated independently for each metal oxide particle observed independently in the microscopic image. Fig. 8B shows an image obtained by subjecting the image of Fig. 8A to binarization processing.
· Noise removal: Despeckle
· Binarization processing: AutoLocal Threshold (Metod = Midgray, Radius = 50)
· Noise removal: Open
· Filling holes in black portions: FillHoles
· Separation of white portions: Watershed

### (Step of Determining Area of Voronoi Region)

The step of determining the areas of Voronoi regions is carried out as follows. By processing the binarized image data, the coordinates of the centroid position of each white portion indicating a metal oxide particle are identified. A binary image is generated in which one pixel located at the coordinates of the centroid of each white portion is white and the other pixels are a black background. For generation of the binary image, the Analyse Perticles function in Fiji is used. Fig. 8C is a binary image generated on the basis of the image of Fig. 8B.

A Voronoi diagram is created by further processing the generated binary image. The Voronoi diagram is generated using the centroid positions of the metal oxide particles as seed points. The average area of the Voronoi regions is calculated from the created Voronoi diagram. The Voronoi command in Fiji is used for creation of the Voronoi diagram and calculation of the average area of the Voronoi regions. The average area of the Voronoi regions is calculated as an average of the areas of the Voronoi regions included in the image.

The value calculated as described above is taken as the average area of Voronoi regions which have, as seed points, the metal oxide particles observed on the first surface. The calculated average area of the Voronoi regions is compared with a predetermined value, and the optical sheet 10 is evaluated on the basis of the average area of the Voronoi regions.

### <<Standard Deviation of Areas of Voronoi Regions>>

Excellent scratch resistance may be imparted to the first surface 11 of the optical sheet 10 by adjusting the area of the Voronoi regions. Lower and upper limits may be set for the standard deviation of the areas of the Voronoi regions. By setting lower and upper limits for the standard deviation of the areas of the Voronoi regions in combination with the numerical range of the average area of the Voronoi regions described above, excellent scratch resistance can be consistently imparted to the entire area of the first surface 11. Similarly, lower and upper limits may be set for the ratio of the standard deviation of the areas of the Voronoi regions to the average area of the Voronoi regions, that is, the coefficient of variation. By setting lower and upper limits for the coefficient of variation in combination with the numerical range of the average area of the Voronoi regions, excellent scratch resistance can be consistently imparted to the entire first surface 11.

The standard deviation of the areas of the Voronoi regions may be 950 nm² or more, may be 1000 nm² or more, may be 1041 nm² or more, may be 1056 nm² or more, may be 1114 nm² or more, or may be 1191 nm² or more. The ratio of the standard deviation of the areas of the Voronoi regions to the average area of the Voronoi regions, that is, the coefficient of variation, may be 0.30 or more, may be 0.34 or more, or may be 0.35 or more.

The standard deviation of the areas of the Voronoi regions may be 2200 nm² or less, may be 2110 nm² or less, may be 1890 nm² or less, may be 1775 nm² or less, or may be 1754 nm² or less. The ratio of the standard deviation of the areas of the Voronoi regions to the average area of the Voronoi regions may be 0.50 or less, may be 0.47 or less, may be 0.45 or less, or may be 0.42 or less.

The standard deviation of the areas of the Voronoi regions may be 950 nm² or more and 2200 nm² or less, may be 1000 nm² or more and 2200 nm² or less, may be 1041 nm² or more and 2200 nm² or less, may be 1056 nm² or more and 2200 nm² or less, may be 1114 nm² or more and 2200 nm² or less, or may be 1191 nm² or more and 2200 nm² or less. The standard deviation of the areas of the Voronoi regions may be 950 nm² or more and 2110 nm² or less, may be 1000 nm² or more and 2110 nm² or less, may be 1041 nm² or more and 2110 nm² or less, may be 1056 nm² or more and 2110 nm² or less, may be 1114 nm² or more and 2110 nm² or less, or may be 1191 nm² or more and 2110 nm² or less. The standard deviation of the areas of the Voronoi regions may be 950 nm² or more and 1890 nm² or less, may be 1000 nm² or more and 1890 nm² or less, may be 1041 nm² or more and 1890 nm² or less, may be 1056 nm² or more and 1890 nm² or less, may be 1114 nm² or more and 1890 nm² or less, or may be 1191 nm² or more and 1890 nm² or less. The standard deviation of the areas of the Voronoi regions may be 950 nm² or more and 1775 nm² or less, may be 1000 nm² or more and 1775 nm² or less, may be 1041 nm² or more and 1775 nm² or less, may be 1056 nm² or more and 1775 nm² or less, may be 1114 nm² or more and 1775 nm² or less, or may be 1191 nm² or more and 1775 nm² or less. The standard deviation of the areas of the Voronoi regions may be 950 nm² or more and 1754 nm² or less, may be 1000 nm² or more and 1754 nm² or less, may be 1041 nm² or more and 1754 nm² or less, may be 1056 nm² or more and 1754 nm² or less, may be 1114 nm² or more and 1754 nm² or less, or may be 1191 nm² or more and 1754 nm² or less.

The ratio of the standard deviation of the areas of the Voronoi regions to the average area of the Voronoi regions, that is, the coefficient of variation, may be 0.30 or more and 0.50 or less, may be 0.34 or more and 0.50 or less, or may be 0.35 or more and 0.50 or less. The coefficient of variation may be 0.30 or more and 0.47 or less, may be 0.34 or more and 0.47 or less, or may be 0.35 or more and 0.47 or less. The coefficient of variation may be 0.30 or more and 0.45 or less, may be 0.34 or more and 0.45 or less, or may be 0.35 or more and 0.45 or less. The coefficient of variation may be 0.30 or more and 0.42 or less, may be 0.34 or more and 0.42 or less, or may be 0.35 or more and 0.42 or less.

As demonstrated in Examples described below, by setting the standard deviation of the areas of the Voronoi regions to 1450 nm² or more and 2150 nm² or less, specifically 1458 nm² or more and 2110 nm² or less, scratch resistance against steel wool was improved. By setting the standard deviation of the areas of the Voronoi regions to 1450 nm² or more and 1800 nm² or less, specifically 1458 nm² or more and 1775 nm² or less, scratch resistance against rubber was improved.

As demonstrated in Examples described below, by setting the coefficient of variation of the area of the Voronoi regions to 0.38 or more, scratch resistance against steel wool was improved. By setting the coefficient of variation of the area of the Voronoi regions to 0.40 or more, scratch resistance against rubber was improved.

### <<Scratch Resistance Test>>

The optical sheet 10 having an adjusted average area of the Voronoi regions has excellent scratch resistance. The optical sheet 10 may have high resistance in a scratch resistance test on the first surface 11 using steel wool. The optical sheet 10 may have high resistance in a scratch resistance test on the first surface 11 using rubber.

### <Steel Wool Scratch Resistance>

A steel wool scratch resistance test is an index of resistance to defects such as scratches generated when steel wool is pressed against a test sample to be evaluated and moved relative thereto. The optical sheet 10 may have resistance to a steel wool scratch resistance test carried out under conditions described below.

A test sample of the optical sheet to be evaluated has a rectangular shape. The short side of the rectangular shape is 50 mm, and the long side thereof is 100 mm. It is visually confirmed that the test sample has no abnormalities such as dust or scratches. The rectangular sample is spread on a testing machine along a horizontal plane so that wrinkles and warpage do not occur. The four corners of the spread sample are fixed to the testing machine using mending tape. The mending tape may be a product with a trade name of "810-3-18" manufactured by 3M Company.

Steel wool as a slider is brought into contact with a surface of the sample constituted by the first surface of the optical sheet. The steel wool is "Bonstar B-204" of grade #0000 manufactured by NIPPON STEEL WOOL Co., Ltd. Bonstar B-204 is of a commercial size having a width of about 390 mm, a length of about 75 mm, and a thickness of about 110 mm. A contact area between the test sample and the slider is 20 mm × 20 mm. A load of 1000 g is applied to the slider from above in a vertical direction, and the slider is pressed against the test sample spread along the horizontal plane.

In a state where the slider is pressed against the test sample from above in a vertical direction, the slider and the sample are moved relative to each other in a horizontal direction. The slider and the sample are moved relative to each other in a direction parallel to a direction in which fibers of the steel wool primarily extend. The relative movement is reciprocation along a linear path. The number of cycles of the reciprocation is 1000. The speed of the reciprocation is 80 mm/s. A stroke of the reciprocation is 40 mm in each of a forward stroke and a return stroke. The reciprocation is in a direction parallel to the long side of the sample.

A test environment is set to have a temperature of 23°C ± 2°C and a relative humidity of 50% ± 5%. The test sample is placed in the test environment for 16 hours before the start of the test.

As the slider, an unused product is used. Before a test on an evaluation target is carried out, pretreatment of steel wool is carried out by rubbing the steel wool against a preparation sample. A testing machine used for a test on a sample to be evaluated is also used for pretreatment of the steel wool. The preparation sample is a polyethylene terephthalate film. The preparation sample has a rectangular shape with a short side of 50 mm and a long side of 100 mm. Steel wool is rubbed against an untreated surface of the polyethylene terephthalate film. The preparation sample is spread along a horizontal plane, and the four corners of the preparation sample are fixed to the testing machine with mending tape. Steel wool is pressed against the preparation sample from above in a vertical direction. A contact area between the preparation sample and the steel wool is 20 mm × 20 mm. A load applied to the steel wool to press the steel wool against the preparation sample is 300 g. The steel wool pressed against the preparation sample is moved relative to the preparation sample in a horizontal direction. The steel wool and the preparation sample are moved relative to each other in a direction parallel to a direction in which fibers of the steel wool primarily extend. The relative movement is reciprocation. The number of cycles of the reciprocation is 300. The speed of the reciprocation is 80 mm/s. A stroke of the reciprocation is 40 mm in each of a forward stroke and a return stroke. The steel wool pressed against the preparation sample in this manner is used for the test on the evaluation target.

After the scratch resistance test, a surface of the test sample constituted by the first surface of the optical sheet is visually observed. An observation distance is 30 cm. An illuminance on the surface of the sample to be observed is 800 lx or more and 1200 lx or less.

When a certain level of defects such as scratches which may cause a problem in application to a display apparatus are observed in the test sample, the test sample of the optical sheet 10 to be evaluated is determined not to have resistance to the scratch resistance test on the first surface 11 using steel wool. The scratch resistance test is carried out five times for one optical sheet 10 to be evaluated. When the certain level of defects which may cause a problem in application to a display apparatus do not occur in all of the five tests, the optical sheet 10 to be evaluated is determined to have resistance to the scratch resistance test on the first surface 11 using steel wool. The certain level of defects which may cause a problem in application to a display apparatus are defects corresponding to scale grade "4" or "5" in a six-point evaluation scale of "0" to "5" described in Examples below. The steel wool is replaced each time in the five tests. The pretreatment of the steel wool described above is carried out before the start of each of the five tests.

### <CS6 Resistance>

A rubber scratch resistance test is an index of resistance to defects such as scratches generated when rubber is pressed against a test sample to be evaluated and moved relative thereto. The optical sheet 10 may have resistance to a scratch resistance test carried out under conditions described below in which a "Jumbo Wearaser (registered trademark), CS-6" manufactured by TABER Industries is used as a slider.

A test sample of the optical sheet to be evaluated has a rectangular shape. The short side of the rectangular shape is 50 mm, and the long side thereof is 100 mm. It is visually confirmed that the test sample has no abnormalities such as dust or scratches. The rectangular sample is spread on a testing machine along a horizontal plane so that wrinkles and warpage do not occur. The four corners of the spread sample are fixed to the testing machine using mending tape. The mending tape may be a product with a trade name of "810-3-18" manufactured by 3M Company.

A "Jumbo Wearaser (registered trademark), CS-6" serving as the slider is composed primarily of rubber. The CS-6 serving as the slider generally has a solid cylindrical shape. A tip end surface of the solid cylindrical shape of the slider is brought into contact with a surface of the sample constituted by the first surface of the optical sheet. A contact area between the test sample and the slider has a circular shape with a diameter of 12 mm.

The CS-6 serving as the slider is held by a holder. The holder is fixed to a side surface of the solid cylindrical shape of the slider. In a state where the CS-6 is held by the holder, the tip end surface of the solid cylindrical shape protrudes by 2 mm from the holder. By limiting the protruding length of the CS-6 from the holder, deformation of the CS-6 during the test is limited. The slider held by the holder is pressed from above in a vertical direction against the test sample spread along a horizontal plane. The load applied to the slider to press the slider against the test sample is 200 g.

In a state where the slider is pressed against the test sample from above in a vertical direction, the slider and the sample are moved relative to each other in a horizontal direction. The relative movement is reciprocation. The number of cycles of the reciprocation is 150. The speed of the reciprocation is 200 mm/s. A stroke of the reciprocation is 50 mm in each of a forward stroke and a return stroke. The reciprocation is in a direction parallel to the long side of the sample.

A test environment is set to have a temperature of 23°C ± 2°C and a relative humidity of 50% ± 5%. The test sample is placed in the test environment for 16 hours before the start of the test.

Before a test on an evaluation target is carried out, pretreatment of the CS-6 is carried out by rubbing the CS-6 against a preparation sample. A testing machine used for a test on a sample to be evaluated is also used for pretreatment of the CS-6. The preparation sample is "single-side, easy-adhesion type: A4160" manufactured by Toyobo Co., Ltd. The preparation sample is spread along a horizontal plane, and the four corners of the preparation sample on a surface which has not been subjected to easy-adhesion treatment (a surface on which PET is exposed) are fixed to the testing machine with mending tape. The CS-6 is pressed against the preparation sample from above in a vertical direction. A contact area between the preparation sample and the CS-6 has a circular shape with a diameter of 12 mm. A load applied to the CS-6 to press the CS-6 against the preparation sample is 600 g. The CS-6 pressed against the preparation sample is moved relative to the preparation sample in a horizontal direction. The relative movement is reciprocation. The number of cycles of the reciprocation is 150. The speed of the reciprocation is 220 mm/s. A stroke of the reciprocation is 50 mm in each of a forward stroke and a return stroke. The CS-6 pressed against the preparation sample in this manner is used for the test on the evaluation target. The test is carried out after confirming that a surface of the pressed CS-6 is flat and has no rubber shavings attached thereto.

After the scratch resistance test, the surface of the test sample constituted by the first surface of the optical sheet is visually observed. An observation distance is 30 cm. An illuminance on the surface of the sample to be observed is 800 lx or more and 1200 lx or less.

When a certain level of defects such as scratches which may cause a problem in application to a display apparatus are observed in the test sample, the test sample of the optical sheet 10 to be evaluated is determined not to have resistance to the scratch resistance test on the first surface 11 using a CS-6 as the slider. The scratch resistance test is carried out five times for one optical sheet 10 to be evaluated. When the certain level of defects which may cause a problem in application to a display apparatus do not occur in the five tests, the optical sheet 10 to be evaluated is determined to have resistance to the scratch resistance test on the first surface 11 using a CS-6 as the slider. The certain level of defects which may cause a problem in application to a display apparatus are a defect corresponding to scale grade "4" or "5" in a six-point evaluation scale of "0" to "5" described in Examples below. The same CS-6 is used in the five tests. The pretreatment of the CS-6 described above is carried out before the start of each of the five tests.

### <<Coefficient of Kinetic Friction>>

An upper limit may be set for the coefficient of kinetic friction on the first surface 11. By setting an upper limit for the coefficient of kinetic friction on the first surface 11, the slidability of the first surface 11 is improved, and scratch resistance may be improved. The coefficient of kinetic friction on the first surface 11 may be 0.95 or less, may be 0.93 or less, may be 0.91 or less, may be 0.90 or less, may be 0.85 or less, may be 0.80 or less, may be 0.78 or less, may be 0.75 or less, or may be 0.70 or less.

The lower limit of the coefficient of kinetic friction on the first surface 11 is not particularly set. The coefficient of kinetic friction on the first surface 11 may be 0 or more, may be greater than 0, may be 0.50 or more, or may be 0.60 or more.

The coefficient of kinetic friction on the first surface 11 may be 0 or more and 0.95 or less, may be 0 or more and 0.93 or less, may be 0 or more and 0.91 or less, may be 0 or more and 0.90 or less, may be 0 or more and 0.85 or less, may be 0 or more and 0.80 or less, may be 0 or more and 0.78 or less, may be 0 or more and 0.75 or less, or may be 0 or more and 0.70 or less. The coefficient of kinetic friction on the first surface 11 may be greater than 0 and 0.95 or less, may be greater than 0 and 0.93 or less, may be greater than 0 and 0.91 or less, may be greater than 0 and 0.90 or less, may be greater than 0 and 0.85 or less, may be greater than 0 and 0.80 or less, may be greater than 0 and 0.78 or less, may be greater than 0 and 0.75 or less, or may be greater than 0 and 0.70 or less. The coefficient of kinetic friction on the first surface 11 may be 0.50 or more and 0.95 or less, may be 0.50 or more and 0.93 or less, may be 0.50 or more and 0.91 or less, may be 0.50 or more and 0.90 or less, may be 0.50 or more and 0.85 or less, may be 0.50 or more and 0.80 or less, may be 0.50 or more and 0.78 or less, may be 0.50 or more and 0.75 or less, or may be 0.50 or more and 0.70 or less. The coefficient of kinetic friction on the first surface 11 may be 0.60 or more and 0.95 or less, may be 0.60 or more and 0.93 or less, may be 0.60 or more and 0.91 or less, may be 0.60 or more and 0.90 or less, may be 0.60 or more and 0.85 or less, may be 0.60 or more and 0.80 or less, may be 0.60 or more and 0.78 or less, may be 0.60 or more and 0.75 or less, or may be 0.60 or more and 0.70 or less.

The coefficient of kinetic friction is determined by cutting a test sample from the optical sheet to be measured, measuring the coefficient of kinetic friction of the test sample, and taking an average of 20 measured values. It is visually confirmed that the test sample has no abnormalities such as dust or scratches. The coefficient of kinetic friction of the test sample is measured as follows.

A test sample of the optical sheet is fixed to an apparatus for measuring the coefficient of kinetic friction as follows. First, the test sample is spread on a table serving as a sample fixing stand so that wrinkles, warpage, and the like do not occur. The table extends along a horizontal plane. The test sample is spread along the horizontal plane. The size of the test sample is 15 cm × 25 cm. The four corners of the spread test sample are fixed to the table with mending tape. The mending tape may be a product with a trade name of "810-3-18" manufactured by 3M Company. In the test sample of the optical sheet fixed to the table, the second surface is in contact with the table, and the first surface faces away from the table.

A slider serving as a counterpart for measuring a coefficient of friction with the first surface 11 is prepared. The slider is a Jumbo Wearaser (registered trademark), CS-6, manufactured by TABER Industries. CS-6 is composed primarily of rubber. The CS-6 serving as the slider is held by a holder in the same manner as in the scratch resistance test described above in which a CS-6 is used as the slider. The slider held by the holder is pressed, from above in a vertical direction, against the test sample spread along a horizontal plane. The slider is brought into contact with the first surface of the test sample. A contact surface between the slider and the test sample has a circular shape with a diameter of 12 mm. The contact surface extends on the horizontal plane. A weight is attached to the holder with double-sided tape. A load applied to the slider to press the slider against the sample is 200 g. A nylon thread is attachable to the holder.

In a state where the slider is pressed against the first surface of the test sample with a load of 200 g from above in a vertical direction, the slider is moved in a horizontal direction. By pulling, in a horizontal direction, the nylon thread connected to the holder using a hook, the slider is moved together with the holder and the weight. The moving direction of the slider is along a long side of the sample. The moving speed of the slider is 15 mm/s. The stroke of the slider is 5 cm. A kinetic friction force acting on the slider in a horizontal direction while the slider is moved through one stroke is measured every 0.01 seconds. An average of measured kinetic friction force values is divided by a pressing load (200 g) applied to the slider against the sample, and the resulting quotient is taken as a coefficient of kinetic friction.

The test environment is set to a temperature of 23°C ± 2°C and a relative humidity of 50% ± 5%. The test sample is placed in the test environment for 16 hours before the start of the test.

Before a test on an evaluation target is carried out, the CS-6 is rubbed against a preparation sample to perform pretreatment of the CS-6. The pretreatment of the CS-6 in an evaluation test of the coefficient of kinetic friction is carried out in the same manner as the pretreatment in the scratch resistance test described above in which a CS-6 is used as the slider. For one test sample, 20 measurements are carried out. An average of measurement values of the coefficient of kinetic friction calculated in the 20 tests is taken as the coefficient of kinetic friction of the evaluation target. The same CS-6 is used in the 20 tests for the evaluation target. The pretreatment of the CS-6 is carried out in each of the 20 tests.

The coefficient of kinetic friction is measured in accordance with JIS K 7125:1999, except for the conditions described above.

### <<Average Particle Size of Metal Oxide Particles>>

An upper limit may be set for the average particle size of the metal oxide particles 42 contained in the functional layer 40. By setting the above-described lower limit of the average area of the Voronoi regions in combination with the upper limit of the average particle size, a dispersion state of the metal oxide particles 42 on the first surface 11 may be more effectively controlled. Adhesion between the binder component 41 and the metal oxide particles 42 in the vicinity of the first surface 11 and a surface state of the first surface 11 can be improved, and scratch resistance of the first surface 11 can be effectively improved.

The average particle size of the metal oxide particles 42 may be smaller than the average thickness of the functional layer 40. The average particle size of the metal oxide particles 42 may be 80% or less of the average thickness of the functional layer 40, may be 75% or less of the average thickness of the functional layer 40, may be 70% or less of the average thickness of the functional layer 40, may be 60% or less of the average thickness of the functional layer 40, or may be 50% or less of the average thickness of the functional layer 40.

When the functional layer 40 functions as a low-reflection layer or a reflection-suppressing layer, the thickness of the functional layer 40 may be small, and the functional layer 40 may contain hollow silica particles 43 as the metal oxide particles. The hollow silica particles 43 typically have a larger average particle size than the other particles contained in the functional layer 40. In this example, a surface state of the first surface 11 greatly depends on a relationship between the average thickness of the functional layer 40 and the average particle size of the hollow silica particles 43. In this example, an upper limit may be set for the average particle size of the hollow silica particles 43. By setting the lower limit of the average area of the Voronoi regions in combination with the upper limit of the average particle size of the hollow silica particles 43, scratch resistance of the first surface 11 can be more effectively improved.

The average particle size of the hollow silica particles 43 may be smaller than the average thickness of the functional layer 40. The average particle size of the hollow silica particles 43 may be 80% or less of the average thickness of the functional layer 40, may be 75% or less of the average thickness of the functional layer 40, may be 70% or less of the average thickness of the functional layer 40, may be 60% or less of the average thickness of the functional layer 40, or may be 50% or less of the average thickness of the functional layer 40.

The term "average particle size" as used for particles such as the metal oxide particles 42 and the hollow silica particles 43 refers to a value determined by the following (1) to (3). Although the particles may aggregate, the average particle size is the average primary particle size.
(1) A cross section of the optical sheet containing particles is observed with a transmission electron microscope (TEM), and an observation image is obtained by imaging.
(2) Ten random particles are extracted from the observation image, and the size of each particle is measured. A particle size (nm) is defined as the distance between a pair of parallel straight lines that sandwich a cross section of a particle, the pair being selected so that the distance between the two straight lines is the largest. That is, the particle size is a maximum length of the particle in the observation image. The particle size is determined as a particle size (maximum length) of each particle. That is, the particle size is a primary particle size.
(3) For the same optical sheet to be measured, the operations of the above (1) and (2) are performed five times, and the particle sizes of a total of 50 particles are measured. The average of the 50 measured particle sizes is defined as the average particle size (nm) of the particles.

The "average thickness" of the functional layer 40 is a value determined by the following (4) to (6).
(4) A cross section of the optical sheet including the functional layer is imaged with a transmission electron microscope (TEM).
(5) In the captured image, the thickness of the functional layer at a central position along a sheet surface of the optical sheet, and the thicknesses of the functional layer at positions shifted by 100 nm to both sides from the central position along the sheet surface of the optical sheet, are measured. The thickness is a length (nm) of the functional layer along a direction orthogonal to the sheet surface of the optical sheet.
(6) For the same optical sheet to be measured, the operations of the above (4) and (5) are performed five times, and the thickness of the functional layer is measured at a total of 15 positions. The average of the 15 measured thicknesses is taken as the average thickness (nm) of the functional layer.

### <<Luminous Reflectance>>

The optical sheet 10 may have a reflection-suppressing function that suppresses reflection of light incident on the first surface 11. The luminous reflectance factor Y on the first surface 11 measured at an incidence angle of 5° may be 1.7% or less, may be 1.5% or less, may be 1.4% or less, may be 1.0% or less, may be 0.8% or less, may be 0.7% or less, may be 0.6% or less, or may be 0.5% or less.

A lower limit is not particularly set for the luminous reflectance. The luminous reflectance factor Y on the first surface 11 measured at an incidence angle of 5° may be 0% or more, or may be greater than 0%.

The luminous reflectance factor Y on the first surface 11 measured at an incidence angle of 5° may be 0% or more and 1.7% or less, may be 0% or more and 1.5% or less, may be 0% or more and 1.4% or less, may be 0% or more and 1.0% or less, may be 0% or more and 0.8% or less, may be 0% or more and 0.7% or less, may be 0% or more and 0.6% or less, or may be 0% or more and 0.5% or less. The luminous reflectance factor Y on the first surface 11 measured at an incidence angle of 5° may be greater than 0% and 1.7% or less, may be greater than 0% and 1.5% or less, may be greater than 0% and 1.4% or less, may be greater than 0% and 1.0% or less, may be greater than 0% and 0.8% or less, may be greater than 0% and 0.7% or less, may be greater than 0% and 0.6% or less, or may be greater than 0% and 0.5% or less.

The luminous reflectance factor Y means the luminous reflectance factor Y in the CIE 1931 standard colorimetric system. The luminous reflectance factor Y (%) is measured as follows using a spectrophotometer.

A sample is cut from the optical sheet 10 to be evaluated. It is visually confirmed that the sample has no abnormalities such as dust or scratches. A black plate is bonded to a surface of the sample constituted by the second surface of the optical sheet with an optically transparent adhesive sheet interposed therebetween. The optically transparent adhesive sheet is "PANACLEAN PD-S1" manufactured by PANAC Co., Ltd. The black plate is "Comoglas DFA2CG 502K (black) series" manufactured by Kuraray Co., Ltd. The black plate has a thickness of 2 mm. The black plate has a total light transmittance of 1% or less. Thus, an evaluation sample A including the optical sheet, the optically transparent adhesive sheet, and the black plate is prepared.

A surface of the evaluation sample A constituted by the first surface of the optical sheet is irradiated with light at an incidence angle of 5°. The reflectance (luminous reflectance factor Y) of the evaluation sample is measured on the basis of light specularly reflected from the evaluation sample A. Using auxiliary illuminant C and a 2° field of view, a luminous reflectance Y (%) is determined on the basis of specular reflectance measured at intervals of 0.5 nm over a range of 300 nm or more and 780 nm or less. Before measurement of the luminous reflectance factor Y of the optical sheet 10, the auxiliary illuminant C is turned on for 15 minutes to stabilize the output of the auxiliary illuminant C. A test environment for measuring the luminous reflectance is set to a temperature of 23°C ± 2°C and a relative humidity of 50% ± 5%. The sample is placed in the test environment for 16 hours before the start of the test.

Other measurement conditions for measuring the luminous reflectance are in accordance with JIS Z 8722:2009.

The luminous reflectance is the arithmetic mean of five measured values. The five measured values are values measured at five measurement positions on the optical sheet to be evaluated. The five measurement positions are located at distances of 10 mm or more from each other.

### <<Total Light Transmittance>>

The total light transmittance of the optical sheet 10 may be 50% or more, may be 70% or more, may be 80% or more, or may be 90% or more. The total light transmittance of the optical sheet 10 has no particular upper limit. The total light transmittance of the optical sheet 10 may be 100% or less or may be less than 100%.

The total light transmittance of the optical sheet 10 may be 50% or more and 100% or less, may be 70% or more and 100% or less, may be 80% or more and 100% or less, or may be 90% or more and 100% or less. The total light transmittance of the optical sheet 10 may be 50% or more and less than 100%, may be 70% or more and less than 100%, may be 80% or more and less than 100%, or may be 90% or more and less than 100%.

A light source simulating a spectrum of D65 standard light (also referred to as a "D65 light source") is used for measuring the total light transmittance (%). Before measuring the total light transmittance of the optical sheet 10, the D65 light source is turned on for 15 minutes to stabilize the output of the D65 light source. An incidence angle to a sample in measuring the total light transmittance is 0°. An incident surface in measuring the total light transmittance is the second surface 12 of the optical sheet 10. A test environment in measuring the total light transmittance is a temperature of 23°C ± 2°C and a relative humidity of 50% ± 5%. The sample is placed in the test environment for 16 hours before the start of the test. Other measurement conditions for measuring the total light transmittance are in accordance with JIS K 7361-1:1997.

The total light transmittance is the arithmetic mean of five measured values. The five measured values are values measured at five measurement positions on the optical sheet to be evaluated. The five measurement positions are located at distances of 10 mm or more from each other.

### <<Transmission Haze>>

The transmission haze of the optical sheet 10 may be 1.0% or less, may be 0.5% or less, or may be 0.2% or less. The transmission haze of the optical sheet 10 has no particular lower limit. The transmission haze of the optical sheet 10 may be 0% or more or may be greater than 0%.

The transmission haze of the optical sheet 10 may be 0% or more and 1.0% or less, may be 0% or more and 0.5% or less, or may be 0% or more and 0.2% or less. The transmission haze of the optical sheet 10 may be greater than 0% and 1.0% or less, may be greater than 0% and 0.5% or less, or may be greater than 0% and 0.2% or less.

The D65 light source is used for measuring the transmission haze (%). Before measuring the transmission haze of the optical sheet 10, the D65 light source is turned on for 15 minutes to stabilize the output of the D65 light source. An incidence angle to a sample in measuring the transmission haze is 0°. An incident surface in measuring the transmission haze is the second surface 12 of the optical sheet 10. A test environment in measuring the transmission haze is a temperature of 23°C ± 2°C and a relative humidity of 50% ± 5%. The sample is placed in the test environment for 16 hours before the start of the test. Other measurement conditions for measuring the transmission haze are in accordance with JIS K 7136:2000.

The transmission haze is the arithmetic mean of five measured values. The five measured values are values measured at five measurement positions on the optical sheet to be evaluated. The five measurement positions are located at distances of 10 mm or more from each other.

With reference to the optical sheet 10 shown in Fig. 1, each layer included in the optical sheet 10 will be described in further detail. As shown in Fig. 1, the optical sheet 10 may further include a resin layer 30. In the example shown in Fig. 1, the substrate 20, the resin layer 30, and the functional layer 40 are laminated in a third direction D3. The illustrated functional layer 40 contains hollow silica particles 43 as metal oxide particles 42. In the following description, the functional layer 40 will be described as a low-reflection layer or a reflection-suppressing layer having a function of suppressing reflection. The functional layer 40 has a refractive index lower than the refractive index of an adjacent layer (the resin layer 30 in the illustrated example).

The third direction D3 is a stacking direction. The substrate 20, the resin layer 30, and the functional layer 40 extend in a first direction D1 and a second direction D2 orthogonal to the third direction D3. In the illustrated example, the first direction D1 and the second direction D2 are orthogonal to each other. In the optical sheet 10 shown in Fig. 1, the first surface 11 is constituted by the functional layer 40. The second surface 12 is constituted by the substrate 20.

The optical sheet 10 may further include an antistatic layer or an antifouling layer, and these layers may be supported by the functional layer 40 to constitute the first surface 11. The antistatic layer, the antifouling layer, and the like are very thin layers. Otherwise, the functional layer 40 cannot effectively exhibit a reflection-suppressing function. Accordingly, even in an example in which the antistatic layer, the antifouling layer, or the like constitutes the first surface 11, scratch resistance of the first surface 11 is affected by the functional layer 40. That is, with the functional layer 40 described above, the scratch resistance of the first surface 11 can be greatly improved.

### <<Substrate>>

The substrate 20 supports the resin layer 30 and the functional layer 40. The substrate 20 may be transparent. "Transparent" means that the total light transmittance in accordance with JIS K 7361-1:1997 is 50% or more, and may be 70% or more, may be 80% or more, or may be 90% or more.

The material of the substrate 20 is not particularly limited. The material of the substrate 20 may be a resin or glass. The resin is preferable in that it is lightweight and is easy to produce.

The resin used for the substrate 20 may be a polyolefin-based resin such as polyethylene or polypropylene. The resin used for the substrate 20 may be a vinyl-based resin such as polyvinyl chloride, polyvinylidene chloride, polyvinyl alcohol, an ethylene-vinyl acetate copolymer, or an ethylene-vinyl alcohol copolymer. The resin used for the substrate 20 may be a polyester-based resin such as polyethylene terephthalate, polyethylene naphthalate, or polybutylene terephthalate. The resin used for the substrate 20 may be an acrylate-based resin such as polymethyl (meth)acrylate or polyethyl (meth)acrylate. The resin used for the substrate 20 may be a styrene-based resin such as polystyrene, may be a polyamide-based resin such as nylon 6 or nylon 66, or may be a cellulose-based resin such as triacetyl cellulose. Examples of the resin used for the substrate 20 further include resins such as polycarbonate; polyimide-based resins; and cycloolefin resins obtained from a cycloolefin such as norbornene or dicyclopentadiene. The resin layer 30 may contain only one kind of the above-described resin, or may contain two or more kinds of the above-described resins.

The thickness of the resin substrate 20 is not particularly limited. From the viewpoint of ease of handling, the thickness of the resin substrate 20 may be 10 µm or more, may be 20 µm or more, or may be 50 µm or more. The thickness of the resin substrate 20 may be 500 µm or less, may be 400 µm or less, or may be 300 µm or less. The thickness of the resin substrate 20 may be 10 µm or more and 500 µm or less, may be 20 µm or more and 500 µm or less, or may be 50 µm or more and 500 µm or less. The thickness of the resin substrate 20 may be 10 µm or more and 400 µm or less, may be 20 µm or more and 400 µm or less, or may be 50 µm or more and 400 µm or less. The thickness of the resin substrate 20 may be 10 µm or more and 300 µm or less, may be 20 µm or more and 300 µm or less, or may be 50 µm or more and 300 µm or less. The thickness of the resin substrate 20 may be 500 µm or more.

In application of the optical sheet 10 to a foldable use, the substrate 20 may have flexibility. In this example, the thickness of the resin substrate 20 may be 10 µm or more and 40 µm or less. When the optical sheet 10 is used in a laminated state with glass, from the viewpoint of preventing scattering of the glass, the thickness of the resin substrate 20 may be 40 µm or more and 100 µm or less.

The substrate 20 may include only a single layer or may include a plurality of layers. The substrate 20 may include a primer layer such as an easy-adhesion layer.

### <<Functional Layer>>

The functional layer 40 contains the binder component 41 and the metal oxide particles 42. The metal oxide particles 42 may include hollow silica particles 43. The metal oxide particles 42 may further include particles other than the hollow silica particles 43. The functional layer 40 contains the hollow silica particles 43, thereby having a reduced refractive index. The functional layer 40 may have a refractive index lower than the refractive index of the binder component 41. The refractive index of the functional layer 40 may be lower than the refractive index of the substrate 20. The refractive index of the functional layer 40 may be lower than the refractive index of a layer adjacent to the functional layer 40.

The functional layer 40 may exhibit a function of suppressing reflection of incident light due to its refractive index and thickness. The antireflection function of the functional layer 40 is based on interference of light reflected at both surfaces of the functional layer 40. From the viewpoint of making the reflection-suppressing function effective, the refractive index of the functional layer 40 may be a value between the refractive indices of two regions adjacent to the functional layer 40 on both sides. The thickness (nm) of the functional layer 40 may be about 1/4 of the wavelength λ (nm) of light whose reflection is to be suppressed.

The thickness of the functional layer may be 60 nm or more and 120 nm or less, may be 70 nm or more and 120 nm or less, or may be 80 nm or more and 120 nm or less. The thickness of the functional layer may be 60 nm or more and 110 nm or less, may be 70 nm or more and 110 nm or less, or may be 80 nm or more and 110 nm or less. The thickness of the functional layer may be 60 nm or more and 100 nm or less, may be 70 nm or more and 100 nm or less, or may be 80 nm or more and 100 nm or less.

From the viewpoint of the reflection-suppressing function, the refractive index of the functional layer and the average thickness of the functional layer may be set as follows. The refractive index of the functional layer may be 1.10 or more, may be 1.20 or more, may be 1.26 or more, may be 1.28 or more, or may be 1.30 or more. The refractive index of the functional layer may be 1.48 or less, may be 1.45 or less, may be 1.40 or less, may be 1.38 or less, or may be 1.35 or less.

The refractive index of the functional layer may be 1.10 or more and 1.48 or less, may be 1.20 or more and 1.48 or less, may be 1.26 or more and 1.48 or less, may be 1.28 or more and 1.48 or less, or may be 1.30 or more and 1.48 or less. The refractive index of the functional layer may be 1.10 or more and 1.45 or less, may be 1.20 or more and 1.45 or less, may be 1.26 or more and 1.45 or less, may be 1.28 or more and 1.45 or less, or may be 1.30 or more and 1.45 or less. The refractive index of the functional layer may be 1.10 or more and 1.40 or less, may be 1.20 or more and 1.40 or less, may be 1.26 or more and 1.40 or less, may be 1.28 or more and 1.40 or less, or may be 1.30 or more and 1.40 or less. The refractive index of the functional layer may be 1.10 or more and 1.38 or less, may be 1.20 or more and 1.38 or less, may be 1.26 or more and 1.38 or less, may be 1.28 or more and 1.38 or less, or may be 1.30 or more and 1.38 or less. The refractive index of the functional layer may be 1.10 or more and 1.35 or less, may be 1.20 or more and 1.35 or less, may be 1.26 or more and 1.35 or less, may be 1.28 or more and 1.35 or less, or may be 1.30 or more and 1.35 or less.

The refractive index used for constituent elements of the optical sheet is a refractive index at a wavelength of 589.3 nm.

The thickness of the functional layer may be 80 nm or more, may be 85 nm or more, or may be 90 nm or more. The thickness of the functional layer may be 150 nm or less, may be 110 nm or less, or may be 105 nm or less. The thickness of the functional layer may be 80 nm or more and 150 nm or less, may be 85 nm or more and 150 nm or less, or may be 90 nm or more and 150 nm or less. The thickness of the functional layer may be 80 nm or more and 110 nm or less, may be 85 nm or more and 110 nm or less, or may be 90 nm or more and 110 nm or less. The thickness of the functional layer may be 80 nm or more and 105 nm or less, may be 85 nm or more and 105 nm or less, or may be 90 nm or more and 105 nm or less.

### <Binder Component>

The binder component 42 is a component that retains the metal oxide particles 42. The binder component 42 may function as a binder for forming a coating film. The functional layer 40 may maintain a film form by the binder component 42 retaining particles contained in the functional layer 40. The binder component 42 may contain a resin. The resin contained in the binder component 42 may be a natural resin or a synthetic resin. The binder component 42 may enclose particles contained in the functional layer 40. The binder component 42 may completely surround each particle contained in the functional layer 40, or may leave at least a part of the particles contained in the functional layer 40 partially exposed.

The binder component 41 may contain a cured product of a curable resin composition. The curable resin composition may include one or more of a thermosetting resin composition and an ionizing radiation-curable resin composition. A cured product of the curable resin composition can impart high strength and high hardness to the functional layer 40, thereby improving the scratch resistance of the first surface 11. The ionizing radiation-curable resin composition is particularly useful from the viewpoint of improving scratch resistance.

The thermosetting resin composition contains a thermosetting resin. The thermosetting resin composition is cured by heating. Examples of the thermosetting resin include an acrylic resin, a urethane resin, a phenolic resin, a urea melamine resin, an epoxy resin, an unsaturated polyester resin, and a silicone resin. The thermosetting resin composition may contain a curing agent.

The ionizing radiation-curable resin composition contains an ionizing radiation-curable compound. The ionizing radiation-curable compound contains an ionizing radiation-curable functional group. Examples of the ionizing radiation-curable functional group include ethylenically unsaturated bond groups such as a (meth)acryloyl group, a vinyl group, and an allyl group; an epoxy group; and an oxetanyl group. The ionizing radiation-curable compound may contain two or more ionizing radiation-curable functional groups. The ionizing radiation-curable compound may be a compound having an ethylenically unsaturated bond group. The ionizing radiation-curable compound may be a (meth)acrylate-based compound having a (meth)acryloyl group.

The ionizing radiation-curable compound may be a siloxane compound containing a siloxane bond. That is, an ultraviolet-curable siloxane compound-containing composition may be used. By forming the functional layer with the ultraviolet-curable siloxane compound-containing composition, the average area of the Voronoi regions can be increased.

The ultraviolet-curable siloxane compound-containing composition is less likely to penetrate into a lower layer as compared with pentaerythritol triacrylate, which is often contained in the functional layer. Therefore, the ultraviolet-curable siloxane compound-containing composition is likely to coat the metal oxide particles contained together in a coating liquid for the functional layer. That is, the metal oxide particles are likely to be enclosed in resin in the functional layer. As a result, in the functional layer formed with the ultraviolet-curable siloxane compound-containing composition, the average area of the Voronoi regions is likely to be large, and the average area of the Voronoi regions can be 2500 nm² or more.

The functional layer formed with the ultraviolet-curable siloxane compound-containing composition contains a cured product of the ultraviolet-curable siloxane compound-containing composition. The binder component of the functional layer formed with the ultraviolet-curable siloxane compound-containing composition contains a cured product of the ultraviolet-curable siloxane compound-containing composition. The functional layer formed with the ultraviolet-curable siloxane compound-containing composition contains a siloxane compound. The binder component of the functional layer formed with the ultraviolet-curable siloxane compound-containing composition contains a siloxane compound. Therefore, in the functional layer containing a siloxane compound, the average area of the Voronoi regions is likely to be large, and the average area of the Voronoi regions can be 2500 nm² or more.

Whether a siloxane compound is contained is confirmed on the basis of whether an organic Si component is detected by X-ray photoelectron spectroscopy. When an organic Si component is detected by X-ray photoelectron spectroscopy, it is determined that a siloxane compound is contained. When an organic Si component is not detected by X-ray photoelectron spectroscopy, it is determined that a siloxane compound is not contained.

An X-ray photoelectron spectroscopy apparatus (XPS) is used for X-ray photoelectron spectroscopy for confirming whether the functional layer contains an organic Si component. An example of the X-ray photoelectron spectroscopy apparatus is an X-ray photoelectron spectroscopy apparatus, AXIS-Nova, manufactured by Kratos Analytical Ltd.

In quantitative analysis of elements present in the functional layer by X-ray photoelectron spectroscopy, X-ray photoelectron spectra of a C1s orbital, an O1s orbital, a Si2p orbital, and an F1s orbital on a surface of the functional layer of a measurement sample are measured under the conditions described below. The following conditions are selected for the measurement.

### (Measurement Conditions)

Measurement method: Wide, Narrow
X-ray source: monochromatic AlKα
X-ray output: 150 W
Emission current: 10 mA
Acceleration voltage: 15 kV
Charge neutralization mechanism: ON
Measurement area: 300 µm × 700 µm
Pass Energy: Survey: 160 eV, Narrow: 40 eV
Photoelectron take-off angle: 90°
Auto Z: ON
Peak shift correction: correction is performed so that the C-C peak in the C1s peak is 285.0 eV
Deconvolution of narrow peaks: performed using a GL function with analysis software attached to the apparatus
Etching ion: Ar monatomic ion

Examples of the siloxane compound include (poly)dimethylsiloxane, (poly)diethylsiloxane, (poly)diphenylsiloxane, (poly)methylphenylsiloxane, alkyl-modified (poly)dimethylsiloxane, azo group-containing (poly)dimethylsiloxane, dimethyl silicone, phenyl methyl silicone, alkyl- or aralkyl-modified silicone, fluorosilicone, polyether-modified silicone, fatty acid ester-modified silicone, methyl hydrogen silicone, silanol group-containing silicone, alkoxy group-containing silicone, phenolic group-containing silicone, methacryl-modified silicone, acryl-modified silicone, amino-modified silicone, carboxylic acid-modified silicone, carbinol-modified silicone, epoxy-modified silicone, mercapto-modified silicone, fluoro-modified silicone, and polyether-modified silicone.

The thickness of the functional layer containing a siloxane compound may be 60 nm or more, may be 70 nm or more, or may be 80 nm or more. The thickness of the functional layer containing a siloxane compound may be 120 nm or less, may be 110 nm or less, or may be 100 nm or less.

The thickness of the functional layer containing a siloxane compound may be 60 nm or more and 120 nm or less, may be 70 nm or more and 120 nm or less, or may be 80 nm or more and 120 nm or less. The thickness of the functional layer containing a siloxane compound may be 60 nm or more and 110 nm or less, may be 70 nm or more and 110 nm or less, or may be 80 nm or more and 110 nm or less. The thickness of the functional layer containing a siloxane compound may be 60 nm or more and 100 nm or less, may be 70 nm or more and 100 nm or less, or may be 80 nm or more and 100 nm or less.

When the functional layer having a thickness in this range contains a siloxane compound, the average area of the Voronoi regions is likely to be large, and the average area of the Voronoi regions can be 2500 nm² or more.

Since formation of a permeation layer is suppressed, the functional layer containing a siloxane compound may achieve a predetermined thickness with high precision. Moreover, in the functional layer containing a siloxane compound, dispersibility of the hollow silica particles is improved. Therefore, by setting the thickness of the functional layer containing a siloxane compound to the above-described numerical range, for example, 60 nm or more and 120 nm or less, the resulting functional layer has a desired thickness and becomes uniform. That is, a highly accurate reflection-suppressing function or low-reflection function may be imparted to the functional layer. Furthermore, the above-described average area of the Voronoi regions is likely to be large, and the average area of the Voronoi regions can be 2500 nm² or more. As a result, the scratch resistance of the first surface can be improved.

A (meth)acrylate-based compound having four or more ethylenically unsaturated bond groups is referred to as a "polyfunctional (meth)acrylate-based compound". A (meth)acrylate-based compound having two or three ethylenically unsaturated bond groups is referred to as a "low-functional (meth)acrylate-based compound".

The (meth)acrylate-based compound may be a monomer or an oligomer. By using the ionizing radiation-curable compound containing a low-functional (meth)acrylate-based compound, uneven shrinkage during curing can be suppressed, and the surface of the functional layer 40 can be smoothed.

The proportion of the low-functional (meth)acrylate-based compound in the ionizing radiation-curable compound may be 60% by mass or more, may be 80% by mass or more, may be 90% by mass or more, may be 95% by mass or more, or may be 100% by mass. From the viewpoint of suppressing uneven shrinkage during curing and smoothing unevenness of the surface of the functional layer 40, the low-functional (meth)acrylate-based compound may be a (meth)acrylate-based compound containing two ethylenically unsaturated bond groups. When the ionizing radiation-curable compound contains a large amount of polyfunctional (meth)acrylate-based compounds, as described below, the surface of the functional layer can be smoothed by appropriately adjusting the type of solvent and drying conditions.

Examples of difunctional (meth)acrylate-based compounds among (meth)acrylate-based compounds include isocyanuric acid di(meth)acrylate; ethylene glycol di(meth)acrylate; polyalkylene glycol di(meth)acrylates such as polyethylene glycol diacrylate and polybutylene glycol di(meth)acrylate; bisphenol A tetraethoxy diacrylate, bisphenol A tetrapropoxy diacrylate, and 1,6-hexanediol diacrylate. Examples of trifunctional (meth)acrylate-based compounds include trimethylolpropane tri(meth)acrylate, pentaerythritol tri(meth)acrylate, and isocyanuric acid-modified tri(meth)acrylate. Examples of polyfunctional (meth)acrylate-based compounds having four or more functional groups include pentaerythritol tetra(meth)acrylate, dipentaerythritol hexa(meth)acrylate, and dipentaerythritol tetra(meth)acrylate. The (meth)acrylate-based compound may be one that is modified as described below.

Examples of (meth)acrylate-based oligomers include acrylate-based polymers such as urethane (meth)acrylate, epoxy (meth)acrylate, polyester (meth)acrylate, and polyether (meth)acrylate. The urethane (meth)acrylate may be obtained, for example, by a reaction of a polyhydric alcohol and an organic diisocyanate with a hydroxy (meth)acrylate. The epoxy (meth)acrylate may be a (meth)acrylate obtained by reacting an aromatic epoxy resin, an alicyclic epoxy resin, an aliphatic epoxy resin, or the like each having three or more functional groups with (meth)acrylic acid. The epoxy (meth)acrylate may also be a (meth)acrylate obtained by reacting an aromatic epoxy resin, an alicyclic epoxy resin, an aliphatic epoxy resin, or the like each having two or more functional groups with a polybasic acid and (meth)acrylic acid. The epoxy (meth)acrylate may also be a (meth)acrylate obtained by reacting an aromatic epoxy resin, an alicyclic epoxy resin, an aliphatic epoxy resin, or the like each having two or more functional groups with a phenol and (meth)acrylic acid.

A part of the molecular skeleton of the (meth)acrylate-based compound may be modified from the viewpoint of suppressing uneven shrinkage due to crosslinking. The (meth)acrylate-based compound may be modified by, for example, ethylene oxide, propylene oxide, caprolactone, isocyanuric acid, alkyl, cyclic alkyl, aromatic, or bisphenol. The (meth)acrylate-based compound may also be modified by an alkylene oxide such as ethylene oxide or propylene oxide. The proportion of the alkylene oxide-modified (meth)acrylate-based compound in the ionizing radiation-curable compound may be 60% by mass or more, may be 80% by mass or more, may be 90% by mass or more, may be 95% by mass or more, or may be 100% by mass. The alkylene oxide-modified (meth)acrylate-based compound may be a low-functional (meth)acrylate-based compound, or may be a (meth)acrylate-based compound having two ethylenically unsaturated bond groups.

Examples of alkylene oxide-modified (meth)acrylate-based compounds having two ethylenically unsaturated bond groups include bisphenol F alkylene oxide-modified di(meth)acrylate, bisphenol A alkylene oxide-modified di(meth)acrylate, isocyanuric acid alkylene oxide-modified di(meth)acrylate, and polyalkylene glycol di(meth)acrylate. The average number of repeating units of the alkylene glycol contained in the polyalkylene glycol di(meth)acrylate may be 3 to 5. The alkylene glycol contained in the polyalkylene glycol di(meth)acrylate may be ethylene glycol and/or polyethylene glycol. Examples of alkylene oxide-modified (meth)acrylate-based compounds having three ethylenically unsaturated bond groups include trimethylolpropane alkylene oxide-modified tri(meth)acrylate and isocyanuric acid alkylene oxide-modified tri(meth)acrylate.

One kind of ionizing radiation-curable compound may be used alone, or two or more kinds of ionizing radiation-curable compounds may be used in combination.

When the ionizing radiation-curable compound is an ultraviolet-curable compound, the curable resin composition that constitutes the binder component 41 may contain additives such as a photopolymerization initiator and a photopolymerization accelerator. Examples of the photopolymerization initiator include one or more selected from acetophenone, benzophenone, α-hydroxyalkylphenone, Michler's ketone, benzoin, benzyl dimethyl ketal, benzoyl benzoate, α-acyloxime ester, α-aminoalkylphenone, thioxanthones, and the like. The photopolymerization accelerator reduces polymerization inhibition due to air during curing and increases the curing rate. Examples of the photopolymerization accelerator include one or more selected from isoamyl p-dimethylaminobenzoate and ethyl p-dimethylaminobenzoate.

### <Metal Oxide Particles and Other Particles>

The metal oxide particles 42 contained in the functional layer 40 may include hollow silica particles 43. The metal oxide particles 42 may include particles other than the hollow silica particles 43. As shown in Fig. 1, the functional layer 40 may contain solid silica particles 44 as the metal oxide particles 42. The functional layer 40 may contain organic particles and inorganic particles other than the metal oxide particles 42. The inorganic particles may be magnesium fluoride particles.

The hollow silica particles 43 have a shell layer composed of silica. In the hollow silica particles 43, the inside of the particles surrounded by the shell layer is hollow. Air may be contained in the hollow. By having an internal hollow, the hollow silica particles 43 have a refractive index lower than the refractive index of silica. The refractive index of the hollow silica particles 43 decreases when the volume of the internal hollow increases. The hollow silica particles 43 reduce the overall refractive index of the functional layer 40. The refractive index of the functional layer 40 can be further reduced by using the hollow silica particles 43 having a large particle size and having a high ratio of internal space.

The hollow silica particles 43 may be uniformly dispersed in the functional layer 40. When the hollow silica particles 43 are uniformly dispersed in the functional layer 40, protrusion of the hollow silica particles 43 from the first surface 11 is suppressed, and the first surface 11 is smoothed. This improves the slidability of the first surface 11 and improves the scratch resistance of the first surface 11. When the hollow silica particles 43 are uniformly dispersed in the functional layer 40, the standard deviation of the areas of the Voronoi regions can be reduced.

The following adjustments are effective from the viewpoint of uniformly dispersing the hollow silica particles 43 in the functional layer 40. The variation in particle size of the hollow silica particles 43 may be reduced. The average particle size of the hollow silica particles 43 relative to the average thickness of the binder component 41 may be adjusted as described above. The affinity between the hollow silica particles 43 and the binder component 41 may be adjusted. The ratio of the content and the ratio of the average particle size between the hollow silica particles 43 and other particles contained in the functional layer 40 may be adjusted. The affinity between the hollow silica particles 43 and other particles contained in the functional layer 40 may be adjusted.

From the viewpoint of uniformly dispersing the hollow silica particles in the functional layer, the binder component of the functional layer may contain a siloxane compound. When the functional layer contains the hollow silica particles and a siloxane compound, the hollow silica particles can be uniformly dispersed in the functional layer. Furthermore, a desired thickness can be imparted to the functional layer. Therefore, a highly accurate reflection-suppressing function or a low-reflection function can be imparted to the functional layer.

The solid silica particles 44 are non-hollow silica particles. The solid silica particles 44 are particles that do not have an internal hollow. The solid silica particles 44 may be solid silica particles.

The average particle size of the solid silica particles 44 is generally smaller than the average particle size of the hollow silica particles 43. Therefore, the solid silica particles 44 can enter the gaps between the hollow silica particles 43 adjacent to each other in the functional layer 40. When the functional layer 40 contains the solid silica particles 44, the strength and hardness of the functional layer 40 can be enhanced, and the scratch resistance of the first surface 11 can be further improved. The refractive index of the solid silica particles 44 is lower than the refractive indices of many of the metal oxide particles 42. Therefore, when the functional layer 40 contains the solid silica particles 44, the refractive index of the functional layer 40 can be reduced. When the functional layer 40 contains the solid silica particles 44, the reflection-suppressing function of the functional layer 40 can be enhanced.

The solid silica particles 44 may be uniformly dispersed in the functional layer 40 together with the hollow silica particles 43. When the solid silica particles 44 are uniformly dispersed in the functional layer 40 together with the hollow silica particles 43, protrusion of the metal oxide particles 42 from the first surface 11 is suppressed, and the first surface 11 is smoothed. This improves the slidability of the first surface 11 and improves the scratch resistance of the first surface 11. When the metal oxide particles 42 are uniformly dispersed in the functional layer 40, the standard deviation of the areas of the Voronoi regions can be reduced. The solid silica particles 44 can be uniformly dispersed in the functional layer 40 together with the hollow silica particles 43 by adjusting the ratio of the content or the ratio of the average particle size between the solid silica particles 44 and the other particles. The solid silica particles 44 can be uniformly dispersed in the functional layer 40 together with the hollow silica particles 43, for example, by adjusting the affinity between the solid silica particles 44 and the other particles.

The functional layer 40 may contain the metal oxide particles 42 other than silica particles. The metal oxide particles 42 other than silica particles may enhance the strength and hardness of the functional layer 40 and may improve the scratch resistance of the first surface 11. Examples of the metal oxide particles 42 include a single oxide of any of alumina and oxides of titanium, tantalum, zirconium, chromium, niobium, cerium, hafnium, and yttrium or a mixture of such oxides. The metal oxide particles 42 other than silica particles may be hollow particles having internal space or may be solid particles not having internal space.

When the functional layer 40 contains the metal oxide particles 42 other than silica particles in addition to the hollow silica particles 43, the scratch resistance of the first surface 11 can be further improved. Details of the reason for the improvement in the scratch resistance are not clear; the following matters are presumed to contribute to improvement in the scratch resistance. The present disclosure is not bound by the following presumption.

In the binder component 41, the metal oxide particles 42 other than silica particles are dispersed in addition to the hollow silica particles 43. The average particle size of the hollow silica particles 43 is generally larger than the average particle size of the metal oxide particles 42 other than silica particles. Therefore, in the binder component 41, the metal oxide particles 42 other than silica particles may be interposed between the hollow silica particles 43. This allows hydroxyl groups of the metal oxide particles 42 other than silica particles to form hydrogen bonds with hydroxyl groups of the hollow silica particles 43. The hydroxyl groups of the metal oxide particles 42 other than silica particles may also form hydrogen bonds with hydroxyl groups of the binder component. That is, it is presumed that, when the metal oxide particles 42 other than silica particles are dispersed in the binder component 41 in addition to the hollow silica particles 43, crosslinking in the functional layer 40 proceeds. The metal oxide particles 42 other than silica particles may connect the hollow silica particles 43 to each other. The metal oxide particles 42 other than silica particles may connect the hollow silica particles 43 and the binder component 41. As described above, it is presumed that, when the functional layer 40 contains the metal oxide particles 42 other than silica particles together with the hollow silica particles 43, the strength and hardness of the functional layer 40 are enhanced, and the scratch resistance of the first surface 11 constituted by the functional layer 40 is enhanced.

The functional layer 40 may contain alumina particles as the metal oxide particles 42 other than silica particles. Alumina particles have a relatively low refractive index among metal oxides. Alumina is aluminum oxide represented by Al₂O₃, and α-type, γ-type, σ-type, and mixtures thereof are known. The alumina particles may be modified alumina particles having a modified surface. Examples of the modified alumina particles include (meth)acrylate-modified alumina particles and silicone-modified alumina particles.

Alumina, which is an oxide of aluminum, can bond to the hollow silica particles 43 and the binder component 41 in the functional layer 40. Therefore, crosslinking proceeds in the functional layer 40, and the functional layer 40 is further reinforced. This enhances the strength and hardness of the functional layer 40 and further improves the scratch resistance of the first surface 11. The average particle size of the alumina particles is generally smaller than the average particle size of the hollow silica particles 43. Therefore, in the functional layer 40, the alumina particles can enter the gaps between the hollow silica particles 43. Accordingly, the scratch resistance of the first surface 11 can be effectively improved.

The alumina particles may be distributed in a surface direction in the vicinity of the surface of the functional layer 40. Therefore, the strength and hardness in the vicinity of the surface of the functional layer 40 are effectively enhanced. For this reason, the scratch resistance against rubber, which is regarded as more severe, can also be effectively enhanced.

By using the metal oxide particles 42 other than silica particles, the total compounding amount of the metal oxide particles 42 in the functional layer 40 can be increased while suppressing protrusion of the metal oxide particles 42 from the first surface 11. This improves the slidability of the first surface 11 and improves the scratch resistance of the first surface 11. When the metal oxide particles 42 are uniformly dispersed in the functional layer 40, the standard deviation of the areas of the Voronoi regions can be reduced.

When a difference between the average particle size of the hollow silica particles 43 and the average particle size of the metal oxide particles 42 other than silica particles is large, aggregation of the metal oxide particles 42 other than silica particles proceeds. Through the aggregated metal oxide particles 42 other than silica particles, two adjacent hollow silica particles 43 are more firmly connected. Through the aggregated metal oxide particles 42 other than silica particles, the hollow silica particles 43 and the binder component 41 are more firmly connected. As a result, the strength and hardness of the functional layer 40 are enhanced, and the scratch resistance of the first surface 11 can be further improved.

The metal oxide particles 42 other than silica particles may also bond to the solid silica particles 44. The metal oxide particles 42 other than silica particles may also form hydrogen bonds with the solid silica particles 44 to promote crosslinking in the functional layer 40. In this regard, the functional layer 40 may contain, as the metal oxide particles 42, the solid silica particles 44 and metal oxide particles other than silica particles.

The shapes of particles dispersed in the functional layer 40, such as the hollow silica particles 43, the solid silica particles 44, and the alumina particles, are not particularly limited. The shapes of particles contained in the functional layer 40 may be substantially spherical shapes such as a true spherical shape, a spheroidal shape, a polyhedral shape approximating a sphere; rod shapes; plate shapes; fibrous shapes; irregular shapes; or the like. When the shapes of particles contained in the functional layer 40 are true spherical shapes, spheroidal shapes, or substantially spherical shapes, the slidability of the first surface 11 is improved, and the scratch resistance of the first surface 11 is improved.

The surfaces of particles contained in the functional layer 40 may be coated with a silane coupling agent. The silane coupling agent may contain a (meth)acryloyl group or an epoxy group. By subjecting the particles to a surface treatment with the silane coupling agent, the affinity between the particles and the binder component is improved, and the particles are less likely to aggregate. As a result, the particles are more uniformly dispersed in the binder component.

Examples of the silane coupling agent include 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-mercaptopropylmethyldimethoxysilane, 3-mercaptopropyltrimethoxysilane, 3-isocyanatopropyltriethoxysilane, methyltrimethoxysilane, dimethyldimethoxysilane, phenyltrimethoxysilane, methyltriethoxysilane, dimethyldiethoxysilane, phenyltriethoxysilane, n-propyltrimethoxysilane, n-propyltriethoxysilane, hexyltrimethoxysilane, hexyltriethoxysilane, octyltriethoxysilane, decyltrimethoxysilane, 1,6-bis(trimethoxysilyl)hexane, trifluoropropyltrimethoxysilane, vinyltrimethoxysilane, and vinyltriethoxysilane. In particular, one or more selected from 3-methacryloxypropylmethyldimethoxysilane, 3-methacryloxypropyltrimethoxysilane, 3-methacryloxypropylmethyldiethoxysilane, and 3-methacryloxypropyltriethoxysilane may be used.

The average particle size of the hollow silica particles 43 may be larger than the average particle size of the solid silica particles 44 and the average particle size of the metal oxide particles 42 other than silica particles. The average particle size of the hollow silica particles 43 may be 50 nm or more, or may be 65 nm or more. The average particle size of the hollow silica particles 43 may be 100 nm or less, or may be 80 nm or less.

The average particle size of the solid silica particles 44 is not particularly limited. The average particle size of the solid silica particles 44 may be 5 nm or more, or may be 10 nm or more. The average particle size of the solid silica particles 44 may be 20 nm or less, or may be 15 nm or less. In addition to the solid silica particles 44 having such an average particle size, or instead of the solid silica particles 44 having such an average particle size, the functional layer 40 may contain solid silica particles 44 having an average particle size of 60 µm or more and 100 µm or less.

The average particle size of the metal oxide particles 42 other than silica particles and the average particle size of the alumina particles may be 5 nm or more, or may be 10 nm or more. The average particle size of the metal oxide particles 42 other than silica particles and the average particle size of the alumina particles may be 20 nm or less, or may be 15 nm or less.

When the content of the hollow silica particles 43 increases, the refractive index of the functional layer 40 decreases, and the functional layer 40 may exhibit an excellent reflection-suppressing function. That is, from the viewpoint of the reflection-suppressing function of the functional layer 40, a lower limit may be set for the content of the hollow silica particles 43. By setting a lower limit for the content of particles other than the hollow silica particles 43, the slidability, strength, and hardness of the functional layer 40 can be ensured. By setting a lower limit for the content of the binder component 41, the particles can be stably retained by the binder component 41. This suppresses detachment of the particles and ensures excellent scratch resistance. By setting an upper limit for the content of the binder component 41, the refractive index of the functional layer 40 may be reduced, and the functional layer 40 may exhibit an excellent reflection-suppressing function. By setting an upper limit for the content of each of the particles, significant aggregation of the particles can be suppressed.

The content of the hollow silica particles may be 100 parts by mass or more, may be 150 parts by mass or more, or may be 175 parts by mass or more, relative to 100 parts by mass of the binder component. The content of the hollow silica particles may be 400 parts by mass or less, may be 300 parts by mass or less, or may be 250 parts by mass or less, relative to 100 parts by mass of the binder component.

The content of the solid silica particles may be 10 parts by mass or more, may be 50 parts by mass or more, may be 70 parts by mass or more, or may be 100 parts by mass or more, relative to 100 parts by mass of the binder component. The content of the solid silica particles may be 200 parts by mass or less, may be 150 parts by mass or less, or may be 100 parts by mass or less, relative to 100 parts by mass of the binder component.

### <Method for Forming Functional Layer 40>

The functional layer 40 may be formed using a coating liquid containing a curable resin composition and particles. The functional layer 40 may be obtained by curing a coating film of the coating liquid. In this example, the coating liquid for the functional layer, used for forming the functional layer 40, may contain additives such as an antistatic agent, an antioxidant, a surfactant, a dispersant, and an ultraviolet absorber.

The coating liquid for the functional layer may contain a silicone-based leveling agent (silicone-based compound) as an additive. When the coating liquid for the functional layer contains a silicone-based leveling agent, protrusion of the hollow silica particles 43 from the first surface 11 is suppressed, and the first surface 11 is smoothed. This improves the slidability of the first surface 11 and improves the scratch resistance of the first surface 11. By using a silicone-based leveling agent, excellent slidability and excellent antifouling properties (fingerprint removability and large contact angles with respect to pure water and hexadecane) can be imparted to the surface of the functional layer 40.

By using a silicone-based leveling agent instead of a fluorine-based leveling agent, generation of PFAS as an impurity can be suppressed. PFAS is a synthetic organofluorine compound whose bioaccumulation is a concern. Suppressing generation of PFAS may contribute to reduction of environmental load.

### <<Resin Layer (Hard Coat Layer)>>

The optical sheet 10 may include a resin layer 30 interposed between the substrate 20 and the functional layer 40. The resin layer 30 contains a cured product of a curable resin composition. The curable resin composition may include one or more of a thermosetting resin composition and an ionizing radiation-curable resin composition. The curable resin composition may contain one or more of a thermosetting resin and an ionizing radiation-curable compound. The resin layer 30 may be a hard coat layer. The resin layer 30 can impart high strength and high hardness to the optical sheet 10 and the first surface 11, and improve the scratch resistance of the first surface 11. The curable resin composition used for forming the resin layer 30 may be the same as the curable resin composition for forming the functional layer 40. The thermosetting resin and the ionizing radiation-curable compound used for forming the resin layer 30 may be the same as the thermosetting resin and the ionizing radiation-curable compound used for forming the functional layer 40.

The thickness of the resin layer 30 may be 0.1 µm or more, may be 0.5 µm or more, or may be 1 µm or more. The thickness of the resin layer 30 may be 100 µm or less, may be 20 µm or less, or may be 10 µm or less. By setting the thickness of the resin layer 30 in this manner, occurrence of cracking during processing such as cutting of the optical sheet 10 can be suppressed while ensuring excellent scratch resistance.

The refractive index of the resin layer 30 may be higher than the refractive index of the functional layer 40 from the viewpoint of the reflection-suppressing function of the functional layer 40. The refractive index of the resin layer 30 may be 1.45 or more and 1.70 or less.

When the optical sheet 10 includes a high-refractive-index layer described below, the refractive index of the resin layer 30 may be lower than the refractive index of the high-refractive-index layer. In this example, the refractive index of the resin layer 30 may be 1.50 or more, or may be 1.55 or more. In this example, the refractive index of the resin layer 30 may be 1.65 or less, or may be 1.60 or less. By setting the refractive index of the resin layer 30 in this manner, the resin layer 30 functions as a medium-refractive-index layer. Interference among the three layers, that is, the resin layer 30 as the medium-refractive-index layer, a second functional layer as a high-refractive-index layer, and the functional layer as the low-refractive-index layer, can occur, thereby further reducing the reflectance. The refractive index of the resin layer 30 can be adjusted by the resin or particles contained in the curable resin composition.

The refractive index is a value determined by fitting a reflection spectrum measured by a reflectometer to a reflection spectrum calculated from an optical model of a multilayer thin-film using Fresnel coefficients.

The resin layer 30 may be formed using a coating liquid containing a curable resin composition. The resin layer 30 may be obtained by curing a coating film of the coating liquid. In this example, the coating liquid for the resin layer, used for forming the resin layer 30, may contain additives that may be applied to the coating liquid for the functional layer. That is, the coating liquid for the resin layer may contain a photopolymerization initiator or a photopolymerization accelerator. The coating liquid for the resin layer may contain a leveling agent.

### <<Second Functional Layer (High-Refractive-Index Layer)>>

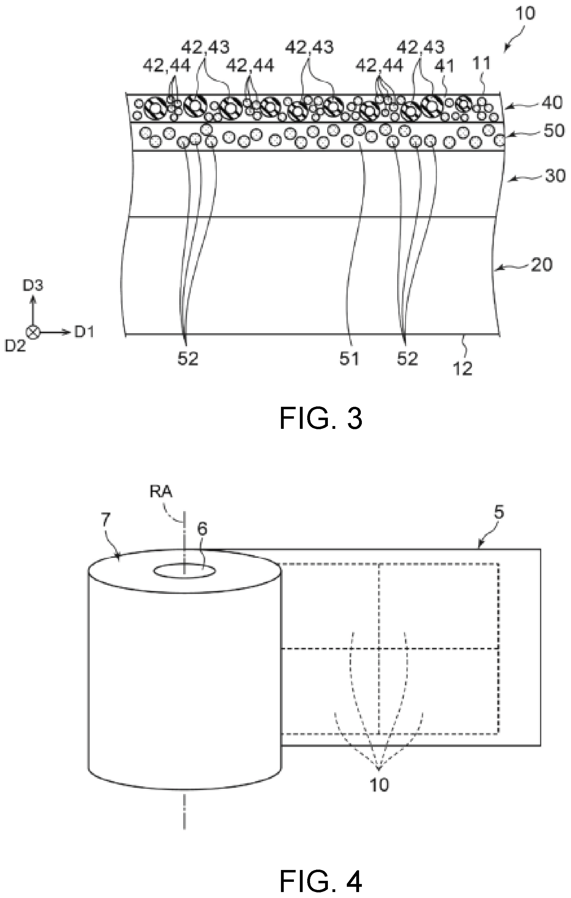

As shown in Fig. 3, the optical sheet 10 may further include a second functional layer 50. The second functional layer 50 is interposed between the functional layer 40 and the resin layer 30 in the third direction D3, which is a stacking direction. The second functional layer 50 is a layer having a refractive index higher than the refractive index of the resin layer 30 and the refractive index of the functional layer 40 and enhances the reflection-suppressing function of the optical sheet 10.

From the viewpoint of the reflection-suppressing function, the refractive index of the second functional layer and the average thickness of the second functional layer may be set as follows. The refractive index of the second functional layer may be 1.55 or more, or may be 1.56 or more. The refractive index of the second functional layer may be 1.85 or less, or may be 1.75 or less. The thickness of the second functional layer may be 50 nm or more. The thickness of the second functional layer may be 200 nm or less, or may be 180 nm or less.

As shown in Fig. 3, the second functional layer 50 may contain a binder component 51 and particles 52. The binder component 51 is a component that retains the particles 52. The binder component 51 may function as a binder for forming a coating film. The second functional layer 50 may maintain a film form by the binder component 51 retaining particles contained in the second functional layer 50. The binder component 51 may contain a resin. The binder component 51 may be configured to be the same as the binder component 41 of the functional layer 40.

The particles 52 are particles for adjusting a refractive index and may have an average particle size on the order of nanometers. The second functional layer 50 may be formed using a curable resin composition, similarly to the functional layer 40. The curable resin composition may include one or more of a thermosetting resin composition and an ionizing radiation-curable resin composition. The curable resin composition may contain one or more of a thermosetting resin and an ionizing radiation-curable compound. The thermosetting resin and the ionizing radiation-curable compound used for forming the second functional layer 50 may be the same as the thermosetting resin and the ionizing radiation-curable compound used for forming the functional layer 40.

The particles 52 may be particles having a refractive index higher than the refractive index of the binder component 51. Examples of the particles 52 include antimony pentoxide, zinc oxide, titanium oxide, cerium oxide, tin-doped indium oxide, antimony-doped tin oxide, yttrium oxide, and zirconium oxide. Zirconium oxide, antimony pentoxide, and titanium oxide can impart high strength and high hardness to the second functional layer 50, thereby contributing to improvement in the scratch resistance of the first surface 11.

The average particle size of the particles 52 may be 5 nm or more, or may be 10 nm or more. The average particle size of the particles 52 may be 200 nm or less, may be 100 nm or less, or may be 80 nm or less. The content of the particles 52 may be set from the viewpoints of an increase in the refractive index of the second functional layer 50 and the strength of the second functional layer 50. The content of the particles 52 may be 100 parts by mass or more, may be 300 parts by mass or more, or may be 500 parts by mass or more, relative to 100 parts by mass of the binder component 51. The content of the particles 52 may be 2500 parts by mass or less, may be 2200 parts by mass or less, or may be 2000 parts by mass or less, relative to 100 parts by mass of the binder component 51.

The second functional layer 50 may be formed using a coating liquid containing a curable resin composition and particles 52. The second functional layer 50 may be obtained by curing a coating film of the coating liquid. In this example, the coating liquid for the second functional layer, used for forming the second functional layer 50, may contain additives that may be applied to the coating liquid for the functional layer. That is, the coating liquid for the second functional layer may contain a photopolymerization initiator or a photopolymerization accelerator. The coating liquid for the second functional layer may contain an antistatic agent, an antioxidant, a surfactant, a dispersant, an ultraviolet absorber, a leveling agent, and the like.

### <<Method for Producing Optical Sheet>>

The resin layer 30, the functional layer 40, and the second functional layer 50 included in the optical sheet 10 may be formed by a wet method. In the wet method, a coating liquid containing components constituting each of the layers 30, 40, and 50 is prepared. The coating liquid is applied to a surface on which each of the layers 30, 40, and 50 is to be formed. A coating film of the coating liquid is dried and cured, thereby obtaining each of the layers 30, 40, and 50. The coating liquid may contain a solvent in addition to a resin composition and particles used for forming each of the layers. The resin composition may contain a solid content constituting each of the layers and additives such as a polymerization initiator.

The optical sheet 10 including the substrate 20 and the functional layer 40 may be produced as follows. A coating liquid for the functional layer, used for forming the functional layer 40, is prepared. The coating liquid for the functional layer is applied to the substrate 20 to form a coating film. The coating film is dried. Then, the coating film is cured. Thus, the functional layer 40 is formed on the substrate 20, and the optical sheet 10 is obtained.

When the optical sheet 10 includes the resin layer 30 in addition to the functional layer 40, the resin layer 30 is formed on the substrate 20 before the functional layer 40 is formed. The resin layer 30 is obtained by applying a coating liquid for the resin layer, used for forming the resin layer 30, to the substrate 20 and drying and curing the coating film. Subsequently, the functional layer 40 is formed on the resin layer 30, thereby obtaining the optical sheet 10. Alternatively, the resin layer 30 may be formed on the substrate 20 in an uncured or semi-cured state, and when the functional layer 40 is cured, the resin layer 30 may be completely cured together with the functional layer 40.

When the optical sheet 10 includes the second functional layer 50 in addition to the resin layer 30 and the functional layer 40, the second functional layer 50 is formed on the resin layer 30 after the resin layer 30 is formed and before the functional layer 40 is formed. The second functional layer 50 is obtained by applying a coating liquid for the second functional layer, used for forming the second functional layer 50, to the resin layer 30 and drying and curing the coating film. Subsequently, the functional layer 40 is formed on the second functional layer 50, thereby obtaining the optical sheet 10. Alternatively, one or more of the resin layer 30 and the second functional layer 50 may be formed in an uncured or semi-cured state, and when the functional layer 40 is cured, one or more of the resin layer 30 and the second functional layer 50 may be completely cured together with the functional layer 40.

By adding a solvent to the coating liquid, the viscosity of the coating liquid can be adjusted, and each component may be dissolved or dispersed in the coating liquid. The solvent may be one or more selected from, for example, ketones (e.g., acetone, methyl ethyl ketone, methyl isobutyl ketone, and cyclohexanone), ethers (e.g., dioxane and tetrahydrofuran), aliphatic hydrocarbons (e.g., hexane), alicyclic hydrocarbons (e.g., cyclohexane), aromatic hydrocarbons (e.g., toluene and xylene), halogenated hydrocarbons (e.g., dichloromethane and dichloroethane), esters (e.g., methyl acetate, ethyl acetate, and butyl acetate), alcohols (e.g., butanol and cyclohexanol), cellosolves (e.g., methyl cellosolve and ethyl cellosolve), cellosolve acetates, sulfoxides (e.g., dimethyl sulfoxide), glycol ethers (e.g., 1-methoxy-2-propyl acetate), and amides (e.g., dimethylformamide and dimethylacetamide).

When volatilization of the solvent is excessively rapid, convection of the solvent occurs actively during drying of the coating liquid. The metal oxide particles 42 contained in the coating liquid, such as the hollow silica particles 43, may move toward the surface of the coating film during drying of the coating liquid, due to the convection caused by volatilization of the solvent. In the produced optical sheet, the particles that have moved toward the surface of the coating film may protrude from the first surface or may form protrusions on the first surface 11. In this optical sheet, a large number of the metal oxide particles are observed on the first surface 11, and the average area of the Voronoi regions is small.

From the viewpoint of increasing the average area of the Voronoi regions, the coating liquid may contain a solvent having a low evaporation rate. The relative evaporation rate of the solvent contained in the coating liquid may be 70 or less, or may be 30 or more and 60 or less. The relative evaporation rate represents the evaporation rate of a target solvent relative to the evaporation rate of n-butyl acetate, with the evaporation rate of n-butyl acetate taken as 100. As an example, the relative evaporation rate of isobutyl alcohol is 64. The relative evaporation rate of 1-butanol is 47. The relative evaporation rate of 1-methoxy-2-propyl acetate is 44. The relative evaporation rate of ethyl cellosolve is 38. The relative evaporation rate of cyclohexanone is 32.

A solvent having a relative evaporation rate of 70 or less may be contained in an amount of 10% by mass or more and 50% by mass or less, or in an amount of 20% by mass or more and 40% by mass or less, based on the total amount of the solvents. In this example, as a solvent other than the solvent having a relative evaporation rate of 70 or less, a solvent having excellent solubility for a resin may be contained in the coating liquid. The relative evaporation rate of the solvent having excellent solubility for a resin may be 100 or more.

A solvent having a high boiling point may be used as a solvent having a low relative evaporation rate. As a solvent having a high boiling point, PMA: propylene glycol monomethyl ether acetate is exemplified. As a solvent having a higher boiling point than PMA, diacetone alcohol is exemplified. As a solvent having a higher boiling point than diacetone alcohol, benzyl acetate is exemplified. By using a coating liquid for forming the functional layer containing a larger amount of a solvent having a high boiling point, the average area of the Voronoi regions can be increased.

The drying temperature during drying of the coating liquid may be adjusted. The air volume and air velocity of drying air during drying of the coating liquid may be adjusted. By also adjusting the drying conditions, movement of the metal oxide particles 42 toward the surface of the coating film during drying of the coating liquid can be suppressed. Therefore, in the produced optical sheet, protrusion of the metal oxide particles 42 from the first surface and formation of protrusions on the first surface 11 can be suppressed. As a result, the average area of the Voronoi regions can be increased.

By weakening the drying conditions, rapid evaporation of the solvent can be suppressed. Generation of a strong upward flow in the coating film can be suppressed. Therefore, accumulation of the metal oxide particles 42 at the surface of the coating film can be suppressed. As a result, the average area of the Voronoi regions can be increased.

The drying conditions may be appropriately selected in accordance with properties of the materials used. When a coating liquid that easily penetrates into an underlayer is used, the drying time may be shortened. By reducing the amount of penetration into an underlayer, accumulation of the metal oxide particles 42 at the surface layer of the coating film can be suppressed. When the metal oxide particles 42 that easily aggregate are used, accumulation of the metal oxide particles 42 at the surface of the coating film can be suppressed by shortening the drying time. As a result, the average area of the Voronoi regions can be increased.

When the substrate 20 is heated during drying of the coating liquid, penetration of the coating liquid into the substrate 20 is promoted. Therefore, the coating liquid may be dried while suppressing penetration of the coating liquid into the substrate 20 by gradually increasing the drying temperature. The drying conditions may be changed between the first half and the second half during drying of the coating liquid.

The proportion of solid content in the coating liquid for forming the functional layer may be adjusted. When the proportion of solid content increases, the viscosity of the coating liquid for forming the functional layer increases. In this example, a state in which resin is attached to the metal oxide particles 42 is likely to be maintained. Therefore, in the produced optical sheet, protrusion of the metal oxide particles 42 from the first surface and formation of protrusions on the first surface 11 can be suppressed. As a result, the average area of the Voronoi regions can be increased.

When the proportion of solid content decreases, the drying time increases. Even when the proportion of solid content is reduced, the average area of the Voronoi regions can be increased in combination with other conditions.

Examples of means for curing a coating film for forming each layer include irradiation with ionizing radiation such as ultraviolet radiation and electron beams, and heating. A curing treatment by irradiation with ionizing radiation is excellent in productivity in that curing can be performed in a short time.

The optical sheet 10 may be produced as described above.

As described above, the average area of Voronoi regions having, as seed points, the metal oxide particles 42 observed on the first surface 11 can be increased by adjusting the type and compounding of the solvent and the drying conditions of the coating film. Instead of or in addition to these methods, the average area of the Voronoi regions may be increased by other methods. For example, the optical sheet 10 may include an overcoat layer. The overcoat layer may be provided to be stacked to the functional layer 40. The overcoat layer may cover the metal oxide particles located at the surface layer of the functional layer 40. The overcoat layer may constitute the first surface 11 of the optical sheet 10. That is, the functional layer 40 may be interposed between the overcoat layer and the substrate 20 in the third direction D3. The thickness of the overcoat layer may be smaller than the thickness of the functional layer 40.

The average area of the Voronoi regions may also be adjusted depending on affinity between the metal oxide particles 42 and the binder component 41. By using the binder component 41 having high affinity for the metal oxide particles 42, the binder component 41 is more likely to surround the metal oxide particles 42. This suppresses protrusion of the metal oxide particles 42 from the binder component 41 and formation of protrusions on the first surface 11. The average area of the Voronoi regions may also be increased depending on the combination of the metal oxide particles 42 and the binder component 41.

The average area of the Voronoi regions can also be adjusted depending on affinity among the metal oxide particles 42 contained in the functional layer 40. By using a plurality of types of metal oxide particles 42 having appropriate affinity, the metal oxide particles 42 may be uniformly dispersed in the binder component 41. This suppresses protrusion of the metal oxide particles 42 from the binder component 41 and formation of protrusions on the first surface 11. The average area of the Voronoi regions may also be adjusted depending on the combination of the metal oxide particles 42 contained in the functional layer 40.

According to the above-described method for producing the optical sheet 10 by a wet method, a long sheet-like article 5 including a large number of optical sheets 10 can be produced as shown in Fig. 4. The optical sheet 10 can be obtained by cutting the long sheet-like article 5 into a predetermined size. In this example, optical sheets 10 having various dimensions can be obtained from the long sheet-like article 5 according to needs. Therefore, optical sheets 10 having various dimensions can be provided in a timely manner. As shown in Fig. 4, ease of handling of the sheet-like article 5 can be improved by handling the sheet-like article 5 as a roll 7 wound around a winding core with a winding axis RA as the central axis.

The method for producing an optical sheet may further include, in addition to the step of producing the optical sheet described above, a step of selecting the produced optical sheet 10. The step of selecting an optical sheet 10 may further include a step of measuring the average area of Voronoi regions having, as seed points, the metal oxide particles observed on the first surface, and a step of selecting an optical sheet in which the average area (nm²) of the Voronoi regions is a predetermined value or more. The predetermined value may be 2500 nm². An optical sheet in which the average area of Voronoi regions having, as seed points, the metal oxide particles observed on the first surface is 2500 nm² or more has excellent scratch resistance. Through this selection step, an optical sheet having excellent scratch resistance can be selected with high accuracy without carrying out a scratch test using steel wool or the like.

### <<<Polarizing Plate 60>>>

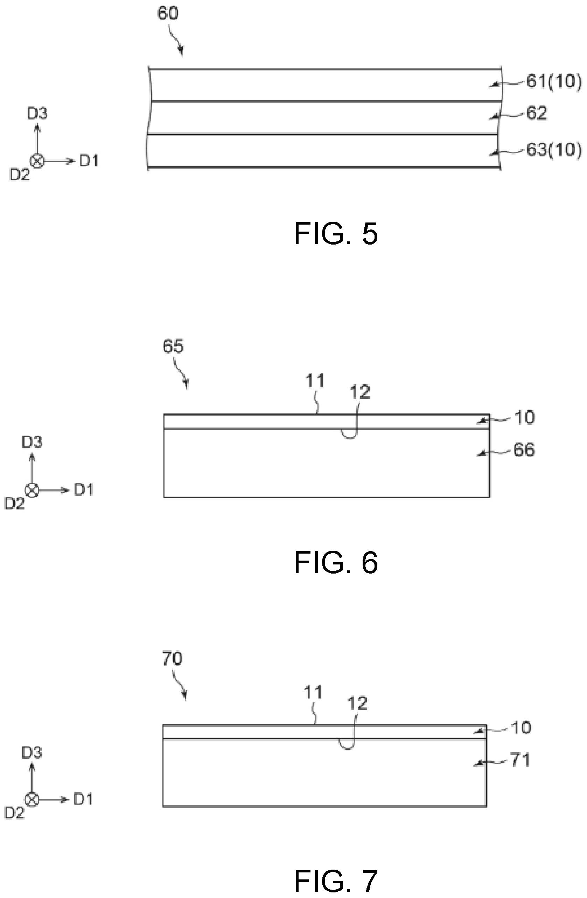

The optical sheet 10 according to the present embodiment may be applied to a polarizing plate 60. In the example shown in Fig. 5, the polarizing plate 60 includes a first protective sheet 61, a polarizer 62, and a second protective sheet 63. The first protective sheet 61 and the second protective sheet 63 sandwich the polarizer 62 therebetween and cover the polarizer 62 from both sides. At least one of the first protective sheet 61 and the second protective sheet 63 may include the optical sheet 10. When only one of the first protective sheet 61 and the second protective sheet 63 includes the optical sheet 10, the other protective sheet may include the substrate 20.

The polarizer 62 transmits one linearly polarized component and blocks the other linearly polarized component. The polarizer 62 may be an absorption-type polarizer that absorbs the other linearly polarized component. The polarizer 62 may be a reflection-type polarizer that reflects the other linearly polarized component. The polarizer 62 may be a sheet-type polarizer such as a polyvinyl alcohol film, a polyvinyl formal film, a polyvinyl acetal film, or a saponified ethylene-vinyl acetate copolymer-based film, each dyed with iodine or the like and stretched. The polarizer 62 may be a wire grid polarizer composed of a large number of metal wires arranged in parallel. The polarizer 62 may be a coated polarizer formed by applying a lyotropic liquid crystal or a dichroic guest-host material, or may be a multilayer thin-film polarizer.

### <<<Image Display Apparatus 65>>>

The optical sheet 10 according to the present embodiment may be applied to a display apparatus 65. In the example shown in Fig. 6, the display apparatus 65 includes an image forming apparatus 66 and the optical sheet 10. The image forming apparatus 66 has a display surface 66a that displays an image. The optical sheet 10 is stacked to the image forming apparatus 66 such that the second surface 12 faces the display surface 66a. The optical sheet 10 may be bonded to the image forming apparatus 66 with a bonding layer interposed therebetween containing an adhesive, a pressure-sensitive adhesive, or the like. An observer can clearly observe an image displayed by the image forming apparatus 66 through the optical sheet 10 while reflection at the first surface 11 of the optical sheet 10 is suppressed. The image forming apparatus 66 is not particularly limited. Examples of the image forming apparatus 66 include a liquid crystal display element, an EL display element, a plasma display element, and an electronic paper element.

### <<<Panel 70>>>

The optical sheet 10 according to the present embodiment can be applied to various uses. Fig. 7 illustrates a panel 70 to which the optical sheet 10 is applied. The panel 70 includes the optical sheet 10 and a bonding target article 71 to which the optical sheet 10 is bonded. The panel 70 constitutes a reflection-suppressing article having a function of suppressing reflection by the optical sheet 10. The optical sheet 10 is stacked to the bonding target article 71 such that the second surface 12 faces the bonding target article 71. The optical sheet 10 may be bonded to the bonding target article 71 with a bonding layer interposed therebetween containing an adhesive, a pressure-sensitive adhesive, or the like. Examples of the bonding target article 71 include an instrument panel, a clock, a showcase, a show window, and a window.

### EXAMPLES

The present disclosure will be described in further detail by way of Examples. The present disclosure is not limited by the following Examples.

### <<<1. Preparation of Optical Sheet>>>

Optical sheets according to Examples 1 to 8 and Comparative Examples 1 to 3 were prepared.

### <<Example 1>>

A coating liquid 1 for a resin layer (coating liquid 1 for an HC layer) having the following formulation was applied to a substrate having a thickness of 80 µm composed of triacetyl cellulose. A coating film of the coating liquid 1 for a resin layer was dried at 70°C for 1 minute to evaporate a solvent. Subsequently, the coating film of the coating liquid 1 for a resin layer was irradiated with ultraviolet rays at a cumulative light dose of 100 mJ/cm². Thus, a resin layer (hard coat layer) having a dry thickness of 10 µm was formed on the substrate.

A coating liquid 1 for a functional layer (coating liquid 1 for a low-refractive-index layer) having the following formulation was applied to the resin layer. A coating film of the coating liquid 1 for a functional layer was dried at 50°C for 30 seconds (drying air velocity: 0.5 m/s), and further dried at 50°C for 30 seconds (drying air velocity: 5 m/s) to evaporate a solvent. Subsequently, the coating film of the coating liquid 1 for a functional layer was irradiated with ultraviolet rays at a cumulative light dose of 200 mJ/cm². Thus, a functional layer (low-refractive-index layer) having a dry thickness of 100 nm was formed, thereby obtaining the optical sheet of Example 1.

### <Coating Liquid 1 for Resin Layer (Coating Liquid 1 for Hard Coat Layer)>

· Solid silica particles: 145 parts by mass
   (average particle size: 12.5 nm; particles that are surface-treated with a silane coupling agent having a methacryloyl group; solid content: 46%)
· Ultraviolet-curable acrylate-containing composition: 100 parts by mass
   (manufactured by Toagosei Co., Ltd.; trade name: "ARONIX M-450"; solid content: 100%)
· Ultraviolet-curable acrylate-containing composition: 42 parts by mass
   (manufactured by DKS Co. Ltd.; trade name: "New Frontier R-1403MB"; solid content: 80%)
· Photopolymerization initiator: 11 parts by mass
   (manufactured by IGM Resins; trade name: "Omnirad 184"; solid content: 100%)
· Silicone-based leveling agent: 6 parts by mass
   (manufactured by Dainichiseika Color & Chemicals Mfg. Co., Ltd.; trade name: "10-301"; solid content: 5%)
· Methyl isobutyl ketone (MIBK): 238 parts by mass
· Methyl ethyl ketone (MEK): 200 parts by mass
· Propylene glycol monomethyl ether (PGME): 40 parts by mass

### <Coating Liquid 1 for Functional Layer (Coating Liquid 1 for Low-Refractive-Index Layer)>

· Hollow silica particles: 2633 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 229 parts by mass
   (manufactured by Toagosei Co., Ltd.; trade name: "MAC-SQ SI-20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1371 parts by mass
   (manufactured by Shin-Etsu Chemical Co., Ltd.; trade name: "X-71-1203M"; solid content: 20%)
· Methyl isobutyl ketone (MIBK): 40663 parts by mass
· Propylene glycol monomethyl ether acetate (PMA): 4879 parts by mass

### <<Example 2>>

Example 2 differs from Example 1 described above in that the coating liquid 1 for a functional layer was changed to the following coating liquid 2 for a functional layer. The optical sheet of Example 2 was obtained using the same materials and the same method as in Example 1 except for this change.

### <Coating Liquid 2 for Functional Layer (Coating Liquid 2 for Low-Refractive-Index Layer)>

· Hollow silica particles: 2633 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 229 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1371 parts by mass
   (manufactured by Shin-Etsu Chemical Co., Ltd.; trade name: "X-71-1203M"; solid content: 20%)
· Methyl isobutyl ketone (MIBK): 35873 parts by mass
· Propylene glycol monomethyl ether acetate (PMA): 9758 parts by mass

### <<Example 3>>

Example 3 differs from Example 1 described above in that the coating liquid 1 for a functional layer was changed to the following coating liquid 3 for a functional layer. The optical sheet of Example 3 was obtained using the same materials and the same method as in Example 1 except for this change.

### <Coating Liquid 3 for Functional Layer (Coating Liquid 3 for Low-Refractive-Index Layer)>

· Hollow silica particles: 2633 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 229 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1371 parts by mass
   (manufactured by Shin-Etsu Chemical Co., Ltd.; trade name: "X-71-1203M"; solid content: 20%)
· Methyl isobutyl ketone (MIBK): 30904 parts by mass
· Propylene glycol monomethyl ether acetate (PMA): 14642 parts by mass

### <<Example 4>>

Example 4 differs from Example 1 described above in that the coating liquid 1 for a functional layer was changed to the following coating liquid 4 for a functional layer. The optical sheet of Example 4 was obtained using the same materials and the same method as in Example 1 except for this change.

### <Coating Liquid 4 for Functional Layer (Coating Liquid 4 for Low-Refractive-Index Layer)>

· Hollow silica particles: 2633 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 229 parts by mass
   (manufactured by Toagosei Co., Ltd.; trade name: "AAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1371 parts by mass
   (manufactured by Shin-Etsu Chemical Co., Ltd.; trade name: "X-71-1203M"; solid content: 20%)
· Methyl isobutyl ketone (MIBK): 30904 parts by mass
· Diacetone alcohol: 14642 parts by mass

### <<Example 5>>

Example 5 differs from Example 1 described above in that the coating liquid 1 for a functional layer was changed to the following coating liquid 5 for a functional layer. The optical sheet of Example 5 was obtained using the same materials and the same method as in Example 1 except for this change.

### <Coating Liquid 5 for Functional Layer (Coating Liquid 5 for Low-Refractive-Index Layer)>

· Hollow silica particles: 2687 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 236 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1398 parts by mass
   (manufactured by Shin-Etsu Chemical Co., Ltd.; trade name: "X-71-1203M"; solid content: 20%)
· Methyl isobutyl ketone (MIBK): 13687 parts by mass
· Diacetone alcohol: 7291 parts by mass

### <<Example 6>>

Example 6 differs from Example 1 described above in that the coating liquid 1 for a functional layer was changed to the following coating liquid 6 for a functional layer. The optical sheet of Example 6 was obtained using the same materials and the same method as in Example 1 except for this change.

### <Coating Liquid 6 for Functional Layer (Coating Liquid 6 for Low-Refractive-Index Layer)>

· Hollow silica particles: 2687 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 236 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1398 parts by mass
   (manufactured by Shin-Etsu Chemical Co., Ltd.; trade name: "X-71-1203M"; solid content: 20%)
· Methyl isobutyl ketone (MIBK): 13687 parts by mass
· Benzyl acetate: 7291 parts by mass

### <<Example 6A>>

Example 6A differs from Example 6 described above in that the coating liquid 6 for a functional layer was changed to the following coating liquid 6A for a functional layer. The optical sheet of Example 6A was obtained using the same materials and the same method as in Example 6 except for this change.

### <Coating Liquid 6A for Functional Layer (Coating Liquid 6A for Low-Refractive-Index Layer)>

· Hollow silica particles: 2642 parts by mass
   (average particle size: 65 nm; particles that are surface-treated with a silane coupling agent having a methacryloyl group; solid content: 20%)
· Solid silica particles: 116 parts by mass
   (average particle size: 9.0 nm; particles that are surface-treated with a silane coupling agent having a methacryloyl group; solid content: 50%)
· Alumina particles: 193 parts by mass
   (average particle size: 15.0 nm; particles that are surface-treated with a silane coupling agent having a methacryloyl group; solid content: 30%)
· Ultraviolet-curable siloxane compound-containing composition: 231 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1462 parts by mass
   (manufactured by Shin-Etsu Chemical Co., Ltd.; trade name: "X-71-1203M"; solid content: 20%)
· Methyl isobutyl ketone (MIBK): 14296 parts by mass
· Benzyl acetate: 7616 parts by mass

### <<Example 6B>>

Example 6B differs from Example 6 described above in that a second functional layer (high-refractive-index layer) was interposed between the functional layer and the resin layer. The optical sheet of Example 6B was obtained using the same materials and the same method as in Example 6 except for this change.

Specifically, the optical sheet of Example 6B was prepared as follows. A resin layer was formed on a substrate using the same materials and the same method as in Example 1. To the resin layer, a coating liquid 1 for a second functional layer (coating liquid 1 for a high-refractive-index layer) having the following formulation was applied. A coating film of the coating liquid 1 for a second functional layer was dried at 70°C for 1 minute to evaporate a solvent. Subsequently, the coating film of the coating liquid 1 for a second functional layer was irradiated with ultraviolet rays at a cumulative light dose of 100 mJ/cm². Thus, a second functional layer (high-refractive-index layer) having a dry thickness of 150 nm was formed. Subsequently, a functional layer (low-refractive-index layer) was formed on the second functional layer using the same materials and the same method as in Example 6, thereby obtaining the optical sheet of Example 6B.

### <Coating Liquid 1 for Second Functional Layer (Coating Liquid 1 for High-Refractive-Index Layer)>

· High-refractive-index particles: 429 parts by mass
   (manufactured by Nippon Shokubai Co., Ltd.; trade name: "Zircostar"; solid content: 70%)
· Ultraviolet-curable siloxane compound-containing composition: 100 parts by mass
   (manufactured by Toagosei Co., Ltd.; trade name: "MAC-SQ SI20"; solid content: 100%)
· Photopolymerization initiator: 16 parts by mass
   (manufactured by IGM Resins; trade name: "Omnirad 127"; solid content: 100%)
· Silicone-based leveling agent: 8 parts by mass
   (manufactured by Dainichiseika Color & Chemicals Mfg. Co., Ltd.; trade name: "10-301"; solid content: 5%)
· Methyl isobutyl ketone: 5779 parts by mass
· Propylene glycol monomethyl ether (PGME): 5914 parts by mass

### <<Example 7>>

Example 7 differs from Example 1 described above in that the coating liquid 1 for a functional layer was changed to the following coating liquid 7 for a functional layer. The optical sheet of Example 7 was obtained using the same materials and the same method as in Example 1 except for this change.

### <Coating Liquid 7 for Functional Layer (Coating Liquid 7 for Low-Refractive-Index Layer)>

· Hollow silica particles: 2687 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 236 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1398 parts by mass
   (manufactured by Shin-Etsu Chemical Co., Ltd.; trade name: "X-71-1203M"; solid content: 20%)
· Methyl isobutyl ketone (MIBK): 11255 parts by mass
· Benzyl acetate: 9723 parts by mass

### <<Example 8>>

Example 8 differs from Example 1 described above in that the coating liquid 1 for a functional layer was changed to the following coating liquid 8 for a functional layer. The optical sheet of Example 8 was obtained using the same materials and the same method as in Example 1 except for this change.

### <Coating Liquid 8 for Functional Layer (Coating Liquid 8 for Low-Refractive-Index Layer)>

· Hollow silica particles: 2669 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Ultraviolet-curable siloxane compound-containing composition: 234 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 13 parts by mass
   (manufactured by IGM Resins; trade name: "Esacure 1001M"; solid content: 100%)
· Leveling agent: 1389 parts by mass
   (manufactured by Shin-Etsu Chemical Co., Ltd.; trade name: "X-71-1203M"; solid content: 20%)
· Methyl isobutyl ketone (MIBK): 6106 parts by mass
· Benzyl acetate: 6273 parts by mass

### <<Comparative Example 1>>

Comparative Example 1 differs from Example 1 described above in that the coating liquid 1 for a functional layer was changed to the following coating liquid 9 for a functional layer. The optical sheet of Comparative Example 1 was obtained using the same materials and the same method as in Example 1 except for this change.

### <Coating Liquid 9 for Functional Layer (Coating Liquid 9 for Low-Refractive-Index Layer)>

· Hollow silica particles: 2645 parts by mass
   (average particle size: 65 nm; particles that are surface-treated with a silane coupling agent having a methacryloyl group; solid content: 20%)
· Solid silica particles: 117 parts by mass
   (average particle size: 9.0 nm; particles that are surface-treated with a silane coupling agent having a methacryloyl group; solid content: 50%)
· Alumina particles: 193 parts by mass
   (average particle size: 15.0 nm; particles that are surface-treated with a silane coupling agent having a methacryloyl group; solid content: 30%)
· Ultraviolet-curable siloxane compound-containing composition: 231 parts by mass
   (manufactured by Toagosei Co., Ltd.; trade name: "MAC-SQ SI20"; solid content: 100%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 14 parts by mass
   (manufactured by IGM Resins; trade name: "Esacure 1001M"; solid content: 100%)
· Silicone-based leveling agent: 97 parts by mass
   (manufactured by Dainichiseika Color & Chemicals Mfg. Co., Ltd.; trade name: "10-301"; solid content: 5%)
· Methyl isobutyl ketone (MIBK): 37986 parts by mass

### <<Comparative Example 2>>

Comparative Example 2 differs from Example 1 described above in that the coating liquid 1 for a functional layer was changed to the following coating liquid 10 for a functional layer. The optical sheet of Comparative Example 2 was obtained using the same materials and the same method as in Example 1 except for this change.

### <Coating Liquid 10 for Functional Layer (Coating Liquid 10 for Low-Refractive-Index Layer)>

· Hollow silica particles: 374 parts by mass
   (average particle size: 65 nm; particles that are surface-treated with a silane coupling agent having a methacryloyl group; solid content: 20%)
· Solid silica particles: 120 parts by mass
   (average particle size: 12.5 nm; particles that are surface-treated with a silane coupling agent having a methacryloyl group; solid content: 46%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 4 parts by mass
   (manufactured by IGM Resins; trade name: "Omnirad 127"; solid content: 100%)
· Leveling agent: 115 parts by mass
   (manufactured by Shin-Etsu Chemical Co., Ltd.; trade name: "X-71-1203M"; solid content: 20%)
· Methyl isobutyl ketone (MIBK): 8544 parts by mass
· Propylene glycol monomethyl ether acetate (PMA): 1000 parts by mass

### <<Comparative Example 3>>

Comparative Example 3 differs from Example 1 described above in that the coating liquid 1 for a functional layer was changed to the following coating liquid 11 for a functional layer. The optical sheet of Comparative Example 3 was obtained using the same materials and the same method as in Example 1 except for this change.

### <Coating Liquid 11 for Functional Layer (Coating Liquid 11 for Low-Refractive-Index Layer)>

· Hollow silica particles: 603 parts by mass
   (average particle size: 65 nm; particles that are surface-treated with a silane coupling agent having a methacryloyl group; solid content: 20%)
· Solid silica particles: 54 parts by mass
   (average particle size: 12.5 nm; particles that are surface-treated with a silane coupling agent having a methacryloyl group; solid content: 46%)
· Ultraviolet-curable acrylate-containing composition: 100 parts by mass
   (manufactured by Toagosei Co., Ltd.; trade name: "ARONIX M-305"; solid content: 100%)
· Photopolymerization initiator: 4 parts by mass
   (manufactured by IGM Resins; trade name: "Omnirad 127"; solid content: 100%)
· Leveling agent: 123 parts by mass
   (manufactured by Shin-Etsu Chemical Co., Ltd.; trade name: "X-71-1203M"; solid content: 20%)
· Methyl isobutyl ketone (MIBK): 8296 parts by mass
· Propylene glycol monomethyl ether acetate (PMA): 990 parts by mass

### <<<2. Measurements and Evaluations>>>

Measurement and evaluation of the optical sheets according to the Examples and Comparative Examples were carried out as described below. The test environment for carrying out each measurement and evaluation was a temperature of 23°C ± 2°C and a relative humidity of 50% ± 5%. Before the start of each measurement and evaluation, the samples to be measured were placed in the test environment for 16 hours.

### <<2-1. Luminous Reflectance Y>>

A sample having a size of 5 cm × 5 cm was cut from each of the optical sheets according to the Examples and Comparative Examples. It was visually confirmed that the samples had no abnormalities such as dust or scratches. The luminous reflectance Y (%) of the optical sheets according to the Examples and Comparative Examples was measured by the above-described method. For the measurement of the luminous reflectance Y, a UV-Vis-NIR spectrophotometer "V780" manufactured by JASCO Corporation was used. Table 1 shows the measurement results of the luminous reflectance Y.

### <<2-2. Total Light Transmittance>>

A sample having a size of 10 cm × 5 cm was cut from each of the optical sheets according to the Examples and Comparative Examples. It was visually confirmed that the samples had no abnormalities such as dust or scratches. The total light transmittance (%) of the optical sheets according to the Examples and Comparative Examples was measured by the above-described method. For the measurement of the total light transmittance, a haze meter "HM-150" manufactured by Murakami Color Research Laboratory Co., Ltd. was used. Table 1 shows the measurement results of the total light transmittance.

### <<2-3. Transmission Haze>>

A sample having a size of 10 cm × 5 cm was cut from each of the optical sheets according to the Examples and Comparative Examples. It was visually confirmed that the samples had no abnormalities such as dust or scratches. The transmission haze (%) of the optical sheets according to the Examples and Comparative Examples was measured by the above-described method. For the measurement of the transmission haze, a haze meter "HM-150" manufactured by Murakami Color Research Laboratory Co., Ltd. was used. Table 1 shows the measurement results of the transmission haze.

### <<2-4. Average Area of Voronoi Regions>>

A sample having a size of 5 mm × 5 mm was cut from each of the optical sheets according to the Examples and Comparative Examples. It was visually confirmed that the samples had no abnormalities such as dust or scratches. The average area (nm²) of Voronoi regions, which have, as seed points, the metal oxide particles observed on the first surface, of the optical sheets according to the Examples and Comparative Examples was measured by the above-described method.

An observation image of the first surface was obtained using a scanning electron microscopy (SEM). As the scanning electron microscope, an ultrahigh-resolution field-emission scanning electron microscope SU-9000 manufactured by Hitachi High-Technologies Corporation was used. As an example, Fig. 8A shows an observation image of Example 1 obtained using the scanning electron microscope.

The image obtained using the scanning electron microscope was subjected to binarization processing using image processing software "ImageJ" and "Fiji". As an example, Fig. 8B shows a binarized image of the first surface of Example 1. The image shown in Fig. 8B was obtained by subjecting the observation image of the first surface shown in Fig. 8A to binarization processing.

On the basis of the binarized image, seed points were identified from the positions of the metal oxide particles observed on the first surface 11 using "ImageJ" and "Fiji". As an example, Fig. 8C shows a distribution of the seed points identified for Example 1. The seed point distribution shown in Fig. 8C was generated on the basis of the observation image of the first surface shown in Fig. 8B.

Subsequently, a Voronoi diagram was created using image processing software "ImageJ" and "Fiji", and the areas (nm²) of the Voronoi regions were measured from the Voronoi diagram. The average area (nm²) of the Voronoi regions was calculated from the measurement results of the areas. The standard deviation (nm²) of the areas of the Voronoi regions was calculated from the measurement results of the areas. The ratio of the standard deviation of the areas of the Voronoi regions to the average area of the Voronoi regions was calculated. The average area (nm²) of the Voronoi regions, the standard deviation (nm²) of the areas of the Voronoi regions, and the ratio of the standard deviation of the areas of the Voronoi regions to the average area of the Voronoi regions are shown in the columns of "Average area", "Standard deviation", and "Standard deviation/average area", respectively, in Table 1.

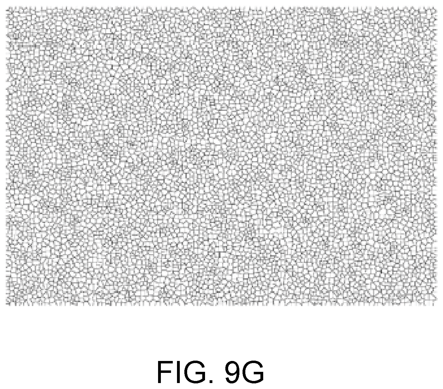

Figs. 9A to 9E show Voronoi diagrams obtained from observation images of the first surface of the optical sheets according to Examples 1 to 5, respectively. Figs. 9F and 9G show Voronoi diagrams obtained from observation images of the first surface of the optical sheets according to Comparative Examples 1 and 2, respectively. The Voronoi diagram shown in Fig. 9A was generated from the seed point distribution shown in Fig. 8C.

### <<2-5. Coefficient of Kinetic Friction>>

A sample having a size of 15 cm × 25 cm was cut from each of the optical sheets according to the Examples and Comparative Examples. It was visually confirmed that the samples had no abnormalities such as dust or scratches. The coefficients of kinetic friction of the optical sheets according to the Examples and Comparative Examples were measured by the above-described method. For the measurement of the coefficient of kinetic friction, an apparatus was used in which a compact tabletop testing machine "EZ-LX" manufactured by Shimadzu Corporation was combined with a coefficient-of-friction measuring apparatus as a friction test jig available from Shimadzu Corporation. Table 1 shows the measurement results of the coefficient of kinetic friction.

### <<2-6. Steel Wool Scratch Resistance Test>>

A sample having a size of 50 mm × 100 mm was cut from each of the optical sheets according to the Examples and Comparative Examples. It was visually confirmed that the samples had no abnormalities such as dust or scratches. A steel wool scratch resistance test was carried out on the optical sheets according to the Examples and Comparative Examples by the above-described method. For the steel wool scratch resistance test, a Gakushin-type rubbing fastness testing machine "AB-301-S" manufactured by Tester Sangyo Co., Ltd. was used.

The sample that had been subjected to 1000 cycles of the steel wool scratch resistance test at a load of 1000 g was removed from the testing machine, and the surface of the sample constituted by the first surface of the optical sheet was observed under the above-described observation conditions. Each sample was evaluated in accordance with the following criteria. In the following criteria, "0" indicates the highest scratch resistance, and the scratch resistance decreases from "0" to "5". For each of the Examples and Comparative Examples, five samples were evaluated, and the worst evaluation result in each Example and Comparative Example is shown in Table 1. In each of the Examples and Comparative Examples in which "0" is shown in Table 1, all of the five samples were evaluated as "0". "0", "1", "2", or "3" does not cause a problem in application to a display apparatus. Accordingly, an optical sheet having an evaluation of "0", "1", "2", or "3" is evaluated as having resistance to the steel wool scratch resistance test. An optical sheet having an evaluation of "4" or "5" is evaluated as not having resistance to the steel wool scratch resistance test. The test conditions of "a load of 1000 g and 1000 cycles" in the steel wool scratch resistance test are more severe than the conditions normally required for antireflection sheets (AR sheets and LR sheets) that are to be bonded to a display surface of a display apparatus.

### (Evaluation Criteria)

5: Detachment of the functional layer was observed.
4: Scratches that may cause a problem in application to a display apparatus were observed.
3: Discoloration due to deformation of the hollow silica and patterns such as shallow scratches were observed on the surface. The discoloration and the patterns were at a level that does not cause a problem in application to a display apparatus.
2: Discoloration due to deformation of the hollow silica was observed on the surface, but no scratches or patterns were observed. The discoloration was at a level that does not cause a problem in application to a display apparatus.
1: Slight discoloration was confirmed by careful observation, but was at a level that is not noticeable under normal observation.
0: No occurrence of discoloration, patterns, or the like was observed at all.

### <<2-7. Rubber Scratch Resistance Test (CS6 Scratch Resistance Test)>>

A sample having a size of 50 mm × 100 mm was cut from each of the optical sheets according to the Examples and Comparative Examples. It was visually confirmed that the samples had no abnormalities such as dust or scratches. A rubber scratch resistance test was carried out on the optical sheets according to the Examples and Comparative Examples by the above-described method. As described above, the slider was a "Jumbo Wearaser (registered trademark), CS-6" manufactured by TABER Industries. For the rubber scratch resistance test, a Gakushin-type rubbing fastness testing machine "AB-301-S" manufactured by Tester Sangyo Co., Ltd. was used.

The sample that had been subjected to 1000 cycles of the rubber scratch resistance test at a load of 250 g was removed from the testing machine, and the surface of the sample constituted by the first surface of the optical sheet was observed under the above-described observation conditions. Each sample was evaluated in accordance with the following criteria. In the following criteria, "0" indicates the highest scratch resistance, and the scratch resistance decreases from "0" to "5". For each of the Examples and Comparative Examples, five samples were evaluated, and the worst evaluation result in each Example and Comparative Example is shown in Table 1. In each of the Examples and Comparative Examples in which "0" is shown in Table 1, all of the five samples were evaluated as "0". "0", "1", "2", or "3" does not cause a problem in application to a display apparatus. Accordingly, an optical sheet having an evaluation of "0", "1", "2", or "3" is evaluated as having resistance to the rubber scratch resistance test. An optical sheet having an evaluation of "4" or "5" is evaluated as not having resistance to the rubber scratch resistance test.

### (Evaluation Criteria)

5: Detachment of the functional layer was observed.
4: Scratches that may cause a problem in application to a display apparatus were observed.
3: Discoloration due to deformation of the hollow silica and patterns such as shallow scratches were observed on the surface. The discoloration and the patterns were at a level that does not cause a problem in application to a display apparatus.
2: Discoloration due to deformation of the hollow silica was observed on the surface, but no scratches or patterns were observed. The discoloration was at a level that does not cause a problem in application to a display apparatus.
1: Slight discoloration was confirmed by careful observation, but was at a level that is not noticeable under normal observation.
0: No occurrence of discoloration, patterns, or the like was observed at all.

**[Table 1]**

| Table 1: Samples and Evaluation Results | | | | | | | | | | | | | | | |
|---|---|---|---|---|---|---|---|---|---|---|---|---|---|---|---|
| | | | Examples | | | | | | | | | | Comparative Examples | | |
| | | | 1 | 2 | 3 | 4 | 5 | 6 | 6A | 6B | 7 | 8 | 1 | 2 | 3 |
| 2-1. | Luminous reflectance Y (%) | | 0.9 | 0.9 | 0.9 | 0.9 | 0.9 | 1.1 | 1.1 | 0.5 | 1.2 | 1.5 | 1.2 | 1.5 | 1.0 |
| 2-2. | Total light transmittance (%) | | 95.2 | 95.2 | 95.2 | 95.3 | 95.1 | 95.2 | 92.5 | 95.5 | 95.3 | 95.2 | 95.2 | 95.2 | 95.2 |
| 2-3. | Transmission haze (%) | | 0.2 | 0.2 | 0.2 | 0.2 | 0.2 | 0.2 | 0.2 | 0.2 | 0.2 | 0.2 | 0.2 | 0.2 | 0.2 |
| 2-4. | Voronoi region | Average area (nm²) | 2976 | 3118 | 2944 | 3222 | 3605 | 4266 | 4289 | 4272 | 4927 | 5549 | 2312 | 2095 | 2236 |
| | | Standard deviation (nm²) | 1114 | 1056 | 1041 | 1191 | 1458 | 1764 | 1754 | 1775 | 1890 | 2110 | 618 | 723 | 945 |
| | | Standard deviation/Average area | 0.37 | 0.34 | 0.35 | 0.37 | 0.40 | 0.41 | 0.41 | 0.42 | 0.38 | 0.38 | 0.27 | 0.35 | 0.42 |
| 2-5. | Coefficient of kinetic friction | | 0.89 | 0.91 | 0.78 | 0.77 | 0.71 | 0.64 | 0.63 : | 0.63 : | 0.61 | : 0.62 | 0.95 | 0.96 | 0.88 |
| 2-6. | Steel wool scratch resistance test | | 2 | 3 | 3 | 2 | 0 | 0 | 0 | 0 | 0 | 0 | 5 | 5 | 5 |
| 2-7. | Rubber scratch resistance test | | 3 | 2 | 2 | 2 | 0 | 0 | 0 | 0 | 1 | 2 | 5 | 5 | 4 |

### Reference Signs List

5: sheet-like article, 6: winding core, 7: roll, 10: optical sheet, 11: first surface, 12: second surface, 20: substrate, 30: resin layer, 40: functional layer, 41: binder component, 42: metal oxide particles, 43: hollow silica particles, 44: solid silica particles, 50: second functional layer, 51: binder component, 52: particles, 60: polarizing plate, 61: first protective sheet, 62: polarizer, 63: second protective sheet, 65: display apparatus, 66: image forming apparatus, 66a: display surface, 70: panel, 71: bonding target article

## Claims

1. An optical sheet including a first surface and a second surface opposing the first surface,
the optical sheet comprising a substrate and a functional layer in this order from the second surface toward the first surface,
wherein the functional layer contains a binder component and metal oxide particles, and
an average area of Voronoi regions having, as seed points, the metal oxide particles observed on the first surface is 2500 nm² or more.

2. The optical sheet according to claim 1, wherein the average area of the Voronoi regions is 3200 nm² or more.

3. The optical sheet according to claim 1, wherein a standard deviation of areas of the Voronoi regions is 950 nm² or more.

4. The optical sheet according to claim 1, wherein a ratio of a standard deviation of areas of the Voronoi regions to the average area of the Voronoi regions is 0.30 or more.

5. The optical sheet according to claim 1, wherein, when a "Jumbo Wearaser (registered trademark), model No. CS-6" manufactured by TABER Industries is used as a slider,
a coefficient of kinetic friction between the first surface and the slider having a load of 200 g applied thereto is 0.95 or less.

6. The optical sheet according to claim 1, having resistance to a scratch resistance test conducted on the first surface using steel wool under conditions below:
Scratch resistance test: steel wool #0000 as a slider; load of 1000 g; moving speed of 80 mm/s; one-way stroke of 40 mm; and 1000 reciprocations.

7. The optical sheet according to claim 1, having resistance to a scratch resistance test conducted on the first surface using rubber under conditions below:
Scratch resistance test: "Jumbo Wearaser (registered trademark), model No. CS-6" manufactured by TABER Industries as a slider; load of 200 g; moving speed of 200 mm/s; one-way stroke of 50 mm; and 150 reciprocations.

8. The optical sheet according to claim 1, wherein the functional layer contains hollow silica particles.

9. The optical sheet according to claim 1, wherein the functional layer contains alumina particles.

10. The optical sheet according to claim 1, wherein the functional layer contains a siloxane compound.

11. The optical sheet according to claim 1, comprising a resin layer located between the substrate and the functional layer,
wherein the resin layer contains a cured product of a curable resin composition.

12. A sheet-like article comprising a plurality of the optical sheets according to any one of claims 1 to 11.

13. The sheet-like article according to claim 12, wound about a winding axis.

14. A polarizing plate comprising a first protective sheet, a polarizer, and a second protective sheet,
wherein at least one of the first protective sheet and the second protective sheet includes the optical sheet according to any one of claims 1 to 11.

15. A display apparatus comprising an image forming apparatus; and
the optical sheet according to any one of claims 1 to 11 stacked to the image forming apparatus.

16. A panel comprising a bonding target article; and
the optical sheet according to any one of claims 1 to 11 bonded to the bonding target article.

17. A method for selecting an optical sheet, relating to an optical sheet having a first surface and a second surface opposing the first surface,
the optical sheet including a substrate and a functional layer in this order from the second surface toward the first surface,
wherein the functional layer contains a binder component and metal oxide particles,
the method comprising,
measuring an average area of Voronoi regions having, as seed points, the metal oxide particles observed on the first surface; and
selecting an optical sheet in which the average area (nm²) of the Voronoi regions is a predetermined value or more.

18. A method for producing an optical sheet, the method comprising:
preparing an optical sheet having a first surface and a second surface opposing the first surface,
wherein the optical sheet includes a substrate and a functional layer in this order from the second surface toward the first surface, and
wherein the functional layer contains a binder component and metal oxide particles; and
selecting an optical sheet in which an average area (nm²) of Voronoi regions having, as seed points, the metal oxide particles observed on the first surface is a predetermined value or more.
